(19) **Europäisches Patentamt**
**European Patent Office**
**Office européen des brevets**

(11) **EP 4 261 559 A1**

(12) **EUROPÄISCHE PATENTANMELDUNG**

(43) Veröffentlichungstag:
**18.10.2023 Patentblatt 2023/42**

(21) Anmeldenummer: **22168603.3**

(22) Anmeldetag: **14.04.2022**

(51) Internationale Patentklassifikation (IPC):
***G01R 33/565*** (2006.01)    ***G01R 33/389*** (2006.01)

(52) Gemeinsame Patentklassifikation (CPC):
**G01R 33/56581;** G01R 33/389

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Healthcare GmbH**
**91052 Erlangen (DE)**

(72) Erfinder: **Dr. Popescu, Stefan**
**91056 Erlangen (DE)**

(54) **VERFAHREN ZUM ABSCHÄTZEN EINER MAGNETFELDABWEICHUNG, EINE MAGNETRESONANZVORRICHTUNG UND EIN COMPUTERPROGRAMMPRODUKT**

(57)   Die Erfindung betrifft ein Verfahren zum Abschätzen einer Magnetfeldabweichung, eine Magnetresonanzvorrichtung und ein Computerprogrammprodukt. Gemäß dem Verfahren wird zumindest ein Gradientenwert bereitgestellt, wobei jeder Gradientenwert eine Gradientenstärke des jeweiligen Gradientenmagnetfeldes, insbesondere des Soll-Gradientenmagnetfeldes, beschreibt. Die Magnetresonanzvorrichtung erzeugt ein Hauptmagnetfeld in einer Hauptmagnetfeldrichtung. Der zumindest eine Abweichungswert wird durch Anwenden des zumindest einen Gradientenwertes auf ein Magnetfeldmodell abgeschätzt. Dabei wird gemäß einem Magnetfeldmodell eine Abweichung des Gradientenmagnetfeldes von einem Soll-Gradientenmagnetfeld durch zumindest eine vektorielle Komponente in einer von der Hauptmagnetfeldrichtung abweichenden Raumrichtung beschrieben.

FIG 4

EP 4 261 559 A1

**Beschreibung**

Die Erfindung betrifft ein Verfahren zum Abschätzen einer Magnetfeldabweichung, eine Magnetresonanzvorrichtung und ein Computerprogrammprodukt.

In der Medizintechnik zeichnet sich die Bildgebung mittels Magnetresonanz (MR), auch Magnetresonanztomographie (MRT, engl. Magnetic Resonance Imaging, MRI) genannt, durch hohe Weichteilkontraste aus. Hierbei wird typischerweise ein menschlicher oder tierischer Patient in einem Bildgebungsvolumen einer Magnetresonanzvorrichtung positioniert. Während einer Magnetresonanzmessung werden üblicherweise mit Hilfe einer Hochfrequenzantenneneinheit der Magnetresonanzvorrichtung gemäß einer Magnetresonanzsequenz hochfrequente Anregungspulse, d.h. elektromagnetische Wechselfelder, in den Patienten eingestrahlt. Davon ist ein durch eine Magnetspuleneinheit der Magnetresonanzvorrichtung erzeugtes Magnetfeld zu unterscheiden, das üblicherweise ein statisches Hauptmagnetfeld und ein oder mehrere sich überlagernde Gradientenmagnetfelder umfasst. Das Hauptmagnetfeld wird von einem, beispielsweise supraleitenden, Hauptmagneten erzeugt. Ferner werden mit Hilfe einer Gradientenspuleneinheit der Magnetresonanzvorrichtung die Gradientenmagnetfelder erzeugt, die üblicherweise zur Ortskodierung der Magnetresonanzsignale dienen. Die Gradientenspuleneinheit kann mehrere Gradientenspulen umfassen, wobei jede der mehreren Gradientenspulen zur Erzeugung eines (Teil- )Gradientenmagnetfeldes mit einem Magnetfeldgradienten in einer bestimmten Raumrichtung, z.B. $X$, $Y$ oder $Z$, ausgelegt ist. (Im Folgenden wird der Begriff "Raumrichtung" synonym zum Begriff "Richtung" verwendet.)

Durch die Anregungspulse werden im Patienten Kernspins angeregt, die um die Feldrichtung des Hauptmagnetfeldes präzedieren, und Magnetresonanzsignale ausgelöst. (Die Hauptmagnetfeldrichtung wird üblicherweise als $Z$-Richtung definiert. Die $Z$-Achse der Magnetresonanzvorrichtung ist in $Z$-Richtung ausgerichtet. $Z$-Richtung und $Z$-Achse werden im Folgenden synonym verwendet.) Die Magnetresonanzsignale werden von der Magnetresonanzvorrichtung empfangen und zur Rekonstruktion von Magnetresonanzabbildungen verwendet.

Im gesamten folgenden Verlauf der Offenbarung werden fettgedruckte Symbole zur Bezeichnung von Vektorgrößen verwendet (beispielsweise ist $\boldsymbol{B}$ der Vektorwert des Magnetfeldes) und normale Symbole zur Bezeichnung des Betrags dieser Vektoren, d.h. $B = |\boldsymbol{B}|$.

Das MR-Bildgebungsverfahren geht seit seinen Anfängen von idealen Voraussetzungen hinsichtlich der zur Aufnahme der Magnetresonanzabbildungen verwendeten Magnetfelder aus, also des statischen Hauptmagnetfeldes $\boldsymbol{B}_0$ und der dynamischen, insbesondere zeitlich und räumlich variierenden, signalkodierenden Gradientenmagnetfelder, die durch die Sequenzparameter $GX$, $GY$ und $GZ$ gesteuert werden. Dabei sind die Sequenzparameter $GX$, $GY$ und $GZ$ Gradientenwerte, die jeweils eine, insbesondere zeitlich und räumlich variierende, Gradientenstärke eines jeweiligen Gradientenmagnetfeldes beschreiben.

Während einer Ausführung einer Magnetresonanzsequenz werden mit der Gradientenspuleneinheit üblicherweise Gradientenpulse (engl. gradient pules) und/oder Gradientenwellenformen (engl. gradient waveforms) $GX(t)$, $GY(t)$ und $GZ(t)$ erzeugt. Dabei variiert die Gradientenstärke eines Gradientenmagnetfeldes als Funktion der Zeit $t$. Es wird angenommen, dass die Stärke des statischen Hauptmagnetfeldes innerhalb des Abbildungsvolumens eine gleichmäßige Verteilung für eine Genauigkeit von weniger als einigen Teilen pro Million (ppm) aufweist. Außerdem wird angenommen, dass die Magnetfeldlinien perfekt gerade und parallel sind, d.h. das Hauptmagnetfeld $\boldsymbol{B}_0$ ist entlang der Hauptmagnetfeldrichtung, im Folgenden die Z-Richtung, mit $B_0 = BZ_0$ orientiert und dass es keine transversalen Vektorkomponenten gibt, d.h. $BX_0 = BY_0 = 0$. Zudem wird auch für die Gradientenmagnetfelder angenommen, dass diese ausschließlich entlang der Z-Richtung orientiert, wobei sie die Stärke von $BZ_0$ linear in Abhängigkeit zur Ortskoordinate (x,y,z) modulieren, d.h.

$$BZ(x,y,z) = BZ_0 + GX \cdot x + GY \cdot y + GZ \cdot z,$$

sowie

$$BX(x,y,z) = BY(x,y,z) = 0$$

Leider weichen die tatsächlichen Verhältnisse in Magnetresonanzvorrichtungen üblicherweise deutlich von diesen idealisieren Annahmen ab. Das statische Hauptmagnetfeld $\boldsymbol{B}_0$ kann signifikant nicht-linear sein, insbesondere an der Peripherie des Bildgebungsvolumens (auch genannt: Sichtfeld, engl. field of view, FOV). Mit diesen Nicht-Linearitäten gehen insbesondere räumliche Variationen der Feldstärke $B_0(x,y,z)$ als auch kleinere lokale Abweichungen der Feldrichtung, d.h. des magnetischen Vektorfeldes $\boldsymbol{B}_0(x,y,z)$, abweichend von der Hauptmagnetfeldrichtung, also der $Z$-Richtung. Oftmals treten diese Nachteile bei Ausgestaltungen von Magnetresonanzvorrichtungen auf, die darauf abzielen, die Kosten für die Magneteinheit zu reduzieren. Es ist wohlbekannt, dass ein hochhomogener Hauptmagnet mit größer werdender Bohrungsöffnung deutlich steigende Herstellungskosten verursacht.

Darüber hinaus ist seit langem bekannt, dass eine reale Gradientenspulen keine idealen Gradientenmagnetfelder erzeugen, die nur entlang der Z-Achse und perfekt parallel zur Richtung von $\boldsymbol{B}_0$ orientiert sind. Stattdessen erzeugen sowohl die axiale Gradientenspule (ZGC) als auch die transversalen Gradientenspulen (XGC und YGC) eine quadrupolare Feldverteilung mit begleitenden Feldkomponenten, die orthogonal zur Z-Achse sind. Diese Komponenten sind in der Fachliteratur als begleitende (engl. concomitant) oder Maxwell-Terme bekannt und sie sind unvermeidlich eine Folge physikalischer Gesetze (wie durch die Maxwell-Gleichungen beschrieben); demnach muss das Vektorfeld des Magnetfeldes eine verschwindende Divergenz und innerhalb des Bildgebungsvolumens eine vernachlässigbare Rotation aufweisen.

Die oben beschriebenen Feldfehler erzeugen spezifische Bildartefakte und erfordern daher verschiedene Erkennungsund Korrektur-Maßnahmen. Beispielsweise ändern die begleitenden Terme die lokale Frequenz des Magnetresonanzsignals, was zu Phasenfehlern und geometrischen Verzerrungen in Magnetresonanzabbildungen führt. Unkorrigierte oder nicht vollständig korrigierte Fehler stellen insbesondere ein großes Hindernis für quantitative Magnetresonanzuntersuchungen dar.

Die Korrektur für die Maxwell-Terme gemäß dem Stand der Technik folgt der in den 1990er Jahren entwickelten Methode von Bernstein. Diese Methode beruht auf einer Entwicklung des magnetischen Vektorfeldes $\boldsymbol{B}$ in eine Taylorreihe, wobei einige Annahmen und Näherungen A1 bis A5 wie folgt getroffen werden:

A1: Die Gradientenmagnetfelder sind im Bildgebungsvolumen perfekt linear.

A2: Es gibt keine orthogonalen X-Y-Gradientenfelder, d.h.

$$\frac{\partial B_y}{\partial x} = \frac{\partial B_x}{\partial y} = 0$$

A3: Die Gradientenmagnetfelder weisen eine zylindrische Symmetrie auf, d.h. $\frac{\partial B_x}{\partial x} = \frac{\partial B_y}{\partial y}$

A4: Das Hauptmagnetfeld $\boldsymbol{B}_0$ ist perfekt homogen und exakt entlang der Z-Achse ausgerichtet.

A5: Die Terme der Taylorreihenentwicklung, die mit $(1/B_0)^2$ und $(1/B_0)^3$ gewichtet sind, können vernachlässigt werden.

Seit seiner Einführung wurde die Bernstein-Methode verwendet, um Maxwell-Terme in verschiedenen MR-Anwendungen zu berücksichtigen, wie weiter im Detail beispielsweise in den Druckschriften US5877629A, US5923168A und US6011392A offenbart ist. Eine kürzlich erschienene Veröffentlichung Wang et al, "FMRI based on transition-band balanced SSFP in comparison with EPI on a high-performance 0.55 T scanner", Magn Reson Med. 2021;85:3196-3210 zeigt, dass die Bernstein-Methode mit ihren Annahmen immer noch unverändert angewendet wird.

Jedoch wird vor allem die Annahme A4 der Bernstein-Methode durch neuere Ausführungen von Magnetresonanzvorrichtungen nicht erfüllt, bei denen die Größe der Patientenbohrung auf 80 cm erweitert und gleichzeitig der Durchmesser des FOV auf mehr als 55 cm erhöht wird. Darüber hinaus führt bei Niedrigfeld-Magnetresonanzvorrichtung, die insbesondere im Bereich von 0,2 bis 0,5 T oder sogar weniger arbeiten, und bei relativ starken Gradienten die Näherung A5 zu erheblichen Fehlern.

Als Aufgabe der vorliegenden Erfindung kann angesehen werden, ein verbessertes Verfahren zum Abschätzen eines Abweichungswertes eines Magnetfeldes, insbesondere von Maxwell-Termen, anzugeben, das insbesondere unrealistische Annahmen der Bernstein-Methode zumindest teilweise vermeidet.

Die Aufgabe wird durch die Merkmale der unabhängigen Ansprüche gelöst. Vorteilhafte Ausgestaltungen sind in den abhängigen Ansprüchen beschrieben.

Demnach wird ein computerimplementiertes Verfahren zum Abschätzen, insbesondere Ermitteln und/oder Bestimmen, zumindest eines Abweichungswertes, insbesondere eines Maxwell-Terms, vorgeschlagen. Dabei beschreibt jeder Abweichungswert, also jeder des zumindest einen Abweichungswertes, eine Abweichung eines Ist-Gradientenmagnetfeldes von einem, insbesondere idealen, Soll-Gradientenmagnetfeld einer Magnetresonanzvorrichtung. Dabei wird zumindest ein Gradientenwert bereitgestellt, wobei jeder Gradientenwert eine Gradientenstärke eines jeweiligen Soll-Gradientenmagnetfeldes beschreibt. Die Magnetresonanzvorrichtung erzeugt ein, insbesondere statisches, Hauptmagnetfeld in einer Hauptmagnetfeldrichtung, insbesondere in einer Raumrichtung des Hauptmagnetfeldes. Das zumindest eine Ist-Gradientenmagnetfeld und/oder das zumindest eine Soll-Gradientenmagnetfeld überlagert sich vorzugsweise, insbesondere räumlich, mit dem Hauptmagnetfeld. Der zumindest eine Abweichungswert wird durch Anwenden des zumindest einen Gradientenwertes auf ein Magnetfeldmodell abgeschätzt. Dabei wird gemäß dem Magnetfeldmodell, insbesondere durch den zumindest einen Abweichungswert, die Abweichung des Ist-Gradientenmagnetfeldes von dem jeweiligen Soll-Gradientenmagnetfeld durch zumindest eine vektorielle Komponente, insbesondere eines Abweichungsfeldes des Ist-Gradientenmagnetfeldes, in einer von der Hauptmagnetfeldrichtung abweichenden Raumrichtung beschrieben.

Das vorgeschlagene Verfahren, insbesondere das Abschätzen des zumindest einen Abweichungswertes, wird vorzugsweise mit Hilfe einer Recheneinheit durchgeführt. Die Recheneinheit kann insbesondere einen oder mehrere Prozessoren und/oder ein oder mehrere Speichermodule umfassen.

Der zumindest eine Abweichungswert kann insbesondere zumindest ein Maxwell-Term sein und/oder durch zumindest einen Maxwell-Term ausgedrückt werden. Der zumindest eine Abweichungswert kann mehrere Abweichungswerte, insbesondere mehrere Maxwell-Terme, umfassen. Insbesondere kann jeder der mehreren Abweichungswerte einen Teil der Abweichung des Ist-Gradientenmagnetfeldes von dem Soll-Gradientenmagnetfeld beschreiben. Beispielsweise kann ein erster Abweichungswert der mehreren Abweichungswerte eine Abweichung in einer ersten Raumrichtung beschreiben und ein zweiter Abweichungswert der mehreren Abweichungswerte eine Abweichung in einer weiteren Raumrichtung, insbesondere in einer zur ersten Raumrichtung orthogonalen Raumrichtung.

Das Ist-Gradientenmagnetfeld ist vorzugsweise ein gemäß dem Magnetfeldmodell abgeschätztes Gradientenmagnetfeld. Vorzugsweise weist das Ist-Gradientenmagnetfeld eine größere Ähnlichkeit mit einem tatsächlich in der Magnetresonanzvorrichtung existierenden Gradientenmagnetfeld auf als das Soll-Gradientenfeld. Idealerweise ist das Ist-Gradientenmagnetfeld identisch mit einem tatsächlich in der Magnetresonanzvorrichtung existierenden Gradientenmagnetfeld. Vorzugsweise ist das Soll-Gradientenfeld ein ideales Gradientenfeld, das insbesondere die vorangehend beschriebenen Annahmen A1, A2 und/oder A3 der Bernstein-Methode erfüllt.

Vorzugsweise ist die Gradientenstärke ein Maß für eine Änderung eines Magnetfeldes, insbesondere eines Betrags des Magnetfeldes, in Abhängigkeit eines Ortes und/oder als Funktion eines Ortes. Vorzugsweise ist die Gradientenstärke ein Maß für einen Magnetfeldgradienten. Die physikalische Einheit der Gradientenstärke kann in mT/m angegeben werden. Der zumindest eine Gradientenwert kann beispielsweise mehrere Gradientenwerte umfassen. Jeder der mehreren Gradientenwerte kann insbesondere eine Gradientenstärke eines jeweiligen Soll-Gradientenmagnetfeldes beschreiben. Idealerweise beschreibt jeder der mehreren Gradientenwerte auch eine tatsächliche Gradientenstärke des jeweiligen Ist-Gradientenmagnetfeldes. Jedes dieser Soll-Gradientenmagnetfelder bzw. Ist-Gradientenfelder kann beispielsweise ein jeweiliges Gradientenmagnetfeld in einer jeweiligen Raumrichtung repräsentieren. Diese verschiedenen Gradientenmagnetfelder können sich zu einem gesamten und/oder resultierenden Gradientenmagnetfeld überlagern.

Das Soll-Gradientenmagnetfeld und/oder die zugehörige Gradientenstärke kann insbesondere durch eine Magnetresonanzsequenz, insbesondere durch einen Gradientenpuls der Magnetresonanzsequenz, festgelegt sein. Die Gradientenstärke kann insbesondere ein Sequenzparameter der Magnetresonanzsequenz sein.

Beispielsweise umfasst das zumindest eine Ist-Gradientenmagnetfeld ein erstes Gradientenmagnetfeld mit einem Magnetfeldgradienten in einer ersten Raumrichtung (z.B. X-Richtung), ein zweites Ist-Gradientenmagnetfeld mit einem Magnetfeldgradienten in einer zweiten Raumrichtung (z.B. Y-Richtung), und/oder ein drittes Ist-Gradientenmagnetfeld mit einem Magnetfeldgradienten in einer dritten Raumrichtung (z.B. Z-Richtung), wobei die erste, zweite und die dritte Raumrichtung orthogonal zueinander sind. Insbesondere wobei überlagern sich das erste Ist-Gradientenmagnetfeld, das zweite Ist-Gradientenmagnetfeld und/oder das dritte Ist-Gradientenmagnetfeld.

Die Magnetresonanzvorrichtung kann eine Gradientenspuleneinheit umfassen. Die Gradientenspuleneinheit kann eine oder mehrere Gradientenspulen umfassen. Jedes der Ist-Gradientenmagnetfelder kann insbesondere durch eine jeweils dafür vorgesehene Gradientenspule der Gradientenspuleneinheit erzeugt werden. Beispielsweise kann die Gradientenspuleneinheit drei Gradientenspulen umfassen, wobei jede der drei Gradientenspulen jeweils ein Gradientenmagnetfeld, insbesondere ein Ist-Gradientenmagnetfeld, in einer jeweiligen Raumrichtung erzeugt. Beispielsweise umfasst die Gradientenspuleneinheit eine Gradientenspule zur Erzeugung eines Gradientenmagnetfeldes, insbesondere eines Ist-Gradientenmagnetfeldes, mit einem Magnetfeldgradienten in einer X-Richtung (X-Gradientenspule, XGC), eine Gradientenspule zur Erzeugung eines Gradientenmagnetfeldes, insbesondere eines Ist-Gradientenmagnetfeldes, mit einem Magnetfeldgradienten in einer Y-Richtung (Y-Gradientenspule, YGC) und eine Gradientenspule zur Erzeugung eines Gradientenmagnetfeldes, insbesondere eines Ist-Gradientenmagnetfeldes, mit einem Magnetfeldgradienten in einer Z-Richtung (Z-Gradientenspule, ZGC).

Die Gradientenspuleneinheit, insbesondere ihre zumindest eine Gradientenspule, kann dynamisch betrieben werden. Die Gradientenmagnetfelder, insbesondere die Ist-Gradientenmagnetfelder, können zeitlich veränderbar sein. Dazu können Gradientenpulse angelegt werden, die beispielsweise einen elektrischen Stromfluss in der zumindest einen Gradientenspule verursachen. Gemäß dem elektrischen Stromfluss und/oder der Geometrie der zumindest einen Gradientenspule kann ein zeitlich und/oder räumlich variables Gradientenmagnetfeld, insbesondere Ist-Gradientenmagnetfeld, erzeugt werden. Das Gradientenmagnetfeld einer jeweiligen Gradientenspule weist typischerweise eine Gradientenstärke von bis zu 500 mT/m, insbesondere bis zu 200 mT/m, insbesondere bis zu 100 mT/m, insbesondere bis zu 50 mT/m auf. Es ist aber nicht ausgeschlossen das zukünftige Magnetresonanzvorrichtungen noch höhere maximale Gradientenstärken aufweisen.

Die Magnetresonanzvorrichtung kann einen Hauptmagneten zur Erzeugung des Hauptmagnetfeldes umfassen. Der Hauptmagnet kann beispielsweise einen supraleitenden Magneten umfassen. Das Hauptmagnetfeld kann beispielsweise eine Stärke von 1,5 T, 3 T oder 7 T aufweisen. Die Stärke des Hauptmagnetfeld ist üblicherweise deutlich größer als die maximale Stärke des zumindest einen Ist-Gradientenmagnetfeldes. Das Hauptmagnetfeld ist üblicherweise zeitlich konstant. In einem Bildgebungsvolumen der Magnetresonanzvorrichtung ist das Hauptmagnetfeld möglichst homogen, d.h. räumlich konstant. Vorzugsweise weist das Hauptmagnetfeld im Bildgebungsvolumen eine Homogenität von weniger 20 ppm, insbesondere weniger als 10 ppm, auf.

Der Hauptmagnet weist beispielsweise eine Zylindergeometrie auf. Die Zylinderachse des Zylinders ist meist in der Hauptmagnetfeldrichtung ausgerichtet. Die Zylinderachse des Zylinders kann insbesondere die Z-Achse der Magnetresonanzvorrichtung sein. Die Hauptmagnetfeldrichtung ist vorzugsweise eine Raumrichtung. Die Hauptmagnetfeldrichtung wird vorzugsweise als Z-Richtung definiert. Die von der Hauptmagnetfeldrichtung abweichende Raumrichtung ist beispielsweise eine X-Richtung und/oder die Y-Richtung.

Das Abschätzen des zumindest einen Abweichungswertes umfasst vorzugsweise ein Ermitteln und/oder Bestimmen des zumindest einen Abweichungswertes. Vorzugsweise werden anhand des zumindest einen Abschätzungswertes Magnetresonanzsignale akquiriert und/oder rekonstruiert.

Vorzugsweise wird bei der Akquisition der Magnetresonanzsignale eine Magnetresonanzsequenz angewendet. Vorteilhafterweise wird die Magnetresonanzsequenz anhand des abgeschätzten zumindest einen Abweichungswertes angepasst.

Vorzugsweise umfasst eine Rekonstruktion der Magnetresonanzsignale eine Erzeugung zumindest einer Magnetresonanzabbildung. Vorteilhafterweise werden dabei die Abweichungen des Ist-Gradientenmagnetfeldes von dem Soll-Gradientenmagnetfeld berücksichtigt. Vorteilhafterweise weisen die rekonstruierten Magnetresonanzabbildungen dadurch eine höhere Qualität, insbesondere weniger Artefakte, auf.

Vorzugsweise wird anhand des bestimmten zumindest einen Abweichungsterms eine Korrektur von Magnetresonanzsignalen, insbesondere von einer Kodierung von Magnetresonanzsignalen, durchgeführt. Insbesondere umfasst die Korrektur eine Berechnung einer Larmorfrequenz in Abhängigkeit des zumindest eines Abweichungswertes.

Vorzugsweise wird eine Rekonstruktion zumindest einer Magnetresonanzabbildung durchgeführt, wobei bei der Rekonstruktion der zumindest einen Magnetresonanzabbildung durch die Abweichung des zumindest einen Ist-Gradientenmagnetfeldes hervorgerufene Phasenfehler anhand des zumindest einen Abweichungswertes korrigiert werden.

Vorteilhafterweise kann durch das (neue) Magnetfeldmodell, das die Abweichung des Ist-Gradientenmagnetfeldes von dem Soll-Gradientenmagnetfeld durch zumindest eine vektorielle Komponente in einer von der Hauptmagnetfeldrichtung abweichenden Raumrichtung beschreibt, das Ist-Gradientenmagnetfeld genauer abgeschätzt werden. Dadurch kann auch die Akquisition und/oder Rekonstruktion genauer erfolgen.

Vorzugsweise weist die zumindest eine vektorielle Komponente eine lineare Abhängigkeit von zumindest einer Koordinate einer Raumrichtung auf. Insbesondere ist jeder der zumindest einen Koordinate eine (eigene) Raumrichtung zugeordnet. Beispielsweise ist der X-Richtung eine x-Koordinate, der Y-Richtung eine y-Koordinate und/oder der Z-Richtung eine z-Koordinate zugeordnet. Vorzugsweise weist die zumindest eine vektorielle Komponente eine lineare Abhängigkeit von zumindest einer Koordinate einer der folgenden Raumrichtungen auf: der Hauptmagnetfeldrichtung und/oder zumindest einer von der Hauptmagnetfeldrichtung abweichenden Raumrichtung. Insbesondere sind die von der Hauptmagnetfeldrichtung abweichenden Raumrichtungen orthogonal zur Hauptmagnetfeldrichtung und/oder orthogonal zueinander. Insbesondere kann die zumindest eine vektorielle Komponente in einer Raumrichtung eine lineare Abhängigkeit von zumindest einer Koordinate einer anderen, insbesondere dazu orthogonalen, Raumrichtung aufweisen.

Vorzugsweise weist die zumindest eine vektorielle Komponente keine Abhängigkeit höherer Ordnung von einer Koordinate einer Raumrichtung auf. Insbesondere weist die zumindest eine vektorielle Komponente in einer Raumrichtung keine Abhängigkeit höherer Ordnung von einer Koordinate einer anderen, insbesondere dazu orthogonalen, Raumrichtung auf. Als eine Abhängigkeit höherer Ordnung kann hier insbesondere eine Abhängigkeit zweiter Ordnung (quadratische Abhängigkeit) und/oder höher angesehen werden.

Vorteilhafterweise wird der zumindest eine Abweichungswert, insbesondere der zumindest eine Maxwell-Term, durch lineare Komponenten dargestellt. Es kann vorteilhafterweise auf eine Taylorreihenentwicklung gemäß der Bernstein-Methode verzichtet werden, die auch Terme höherer Ordnung aufweist.

Das (neue) Magnetfeldmodell basiert insbesondere auf der nichtnaheliegenden Erkenntnis des Erfinders, dass das Hauptmagnetfeld und/oder das zumindest eine Ist-Gradientenmagnetfeld jeweils durch ein Vektorfeld beschreibbar sind, wobei gemäß dem Magnetfeldmodell die Rotation des Vektorfeldes des Hauptmagnetfeldes und die Rotation jedes Vektorfeldes des zumindest einen Ist-Gradientenmagnetfeldes jeweils Null sind, und wobei gemäß dem Magnetfeldmodell die Divergenz des Vektorfeldes des Hauptmagnetfeldes und die Rotation jedes Vektorfeldes des zumindest einen Ist-Gradientenmagnetfeldes jeweils Null sind.

Die Beträge der Vektoren des Vektorfeldes des Magnetfeldes beschreiben üblicherweise ein Skalarfeld; der zugehörige Magnetfeldgradient kann als Vektor angesehen werden, der in Richtung des steilsten Anstiegs dieser Beträge weist, und der Betrag des Magnetfeldgradienten, d.h. die Gradientenstärke, entspricht der Stärke dieses Anstiegs.

Beispielsweise ändern sich die Beträge des ersten Ist-Gradientenmagnetfeldes bzw. zugehörigen Soll-Gradientenmagnetfeldes in der ersten Richtung, insbesondere linear, und die Beträge des zweiten Gradientenmagnetfeldes bzw. zugehörigen Soll-Gradientenmagnetfeldes ändern sich in der zweiten Richtung, insbesondere linear, und sich die Beträge des dritten Gradientenmagnetfeldes bzw. zugehörigen Soll-Gradientenmagnetfeldes ändern sich in der dritten Richtung, insbesondere linear.

Vorzugsweise ist ein Vektorfeld des Hauptmagnetfeldes in der Hauptmagnetfeldrichtung ausgerichtet, wobei das (tatsächliche) Ist-Vektorfeld des zumindest einen Ist-Gradientenmagnetfeldes zumindest einen Vektor aufweist, der zumindest eine Vektorkomponente aufweist, die von der Hauptmagnetfeldrichtung abweicht, wobei der zumindest ein Abweichungswert diese Abweichung beschreibt.

Insbesondere weist das (jeweilige) Vektorfeld des zumindest einen Ist-Gradientenmagnetfeldes Vektoren auf, die idealerweise eine Gleichrichtung gemäß dem zugehörigen Soll-Gradientenmagnetfeld aufweisen, wobei der zumindest eine Abweichungsterm eine (tatsächliche) Abweichung von dieser (idealen) Gleichrichtung beschreibt. Insbesondere ist die Gleichrichtung die Hauptmagnetrichtung.

Vorzugsweise sind die erste Raumrichtung eine X-Richtung, die zweite Raumrichtung eine Y-Richtung und die dritte Raumrichtung eine Z-Richtung, wobei die Z-Richtung die Hauptmagnetfeldrichtung ist, wobei gemäß dem Magnetfeldmodell für den zumindest einen Abweichungswert gilt: $B_{gx,x} = z \cdot GX$, $\boldsymbol{B_{gx,y}} = 0$ für das erste Ist-Gradientenmagnetfeld, $\boldsymbol{B_{gy,x}} = 0$, $\boldsymbol{B_{gy,y}} = \boldsymbol{z \cdot GY}$ für das zweite Ist-Gradientenmagnetfeld und/oder $B_{gz,x} = -x\frac{GZ}{2}$, $B_{gz,y} = -y\frac{GZ}{2}$ für das dritte Ist-Gradientenmagnetfeld. Dabei sind GX die Gradientenstärke in X-Richtung, GY die Gradientenstärke in Y-Richtung, GZ die Gradientenstärke in Z-Richtung, x eine Koordinate in X-Richtung, y eine Koordinate in Y-Richtung, und z eine Koordinate in Z-Richtung.

Insbesondere beschreibt $B_{gx,x}$ eine Abweichung (des tatsächlichen Vektorfeldes des Gradientenmagnetfeldes) in X-Richtung, wenn ein Magnetfeldgradient in X-Richtung angelegt wird. Insbesondere beschreibt $B_{gx,y}$ eine Abweichung (des tatsächlichen Vektorfeldes des Gradientenmagnetfeldes) in Y-Richtung, wenn ein Magnetfeldgradient in X-Richtung angelegt wird. Insbesondere beschreibt $B_{gy,x}$ eine Abweichung (des tatsächlichen Vektorfeldes des Gradientenmagnetfeldes) in X-Richtung, wenn ein Magnetfeldgradient in Y-Richtung angelegt wird. Insbesondere beschreibt $B_{gy,y}$ eine Abweichung (des tatsächlichen Vektorfeldes des Gradientenmagnetfeldes) in Y-Richtung, wenn ein Magnetfeldgradient in Y-Richtung angelegt wird. Insbesondere beschreibt $B_{gz,x}$ eine Abweichung (des tatsächlichen Vektorfeldes des Gradientenmagnetfeldes) in X-Richtung, wenn ein Magnetfeldgradient in Z-Richtung angelegt wird. Insbesondere beschreibt $B_{gz,y}$ eine Abweichung (des tatsächlichen Vektorfeldes des Gradientenmagnetfeldes) in Y-Richtung beschreibt, wenn ein Magnetfeldgradient in Z-Richtung angelegt wird.

Insbesondere kann das Verfahren ferner ein Bereitstellen zumindest eines Parameters, der das Hauptmagnetfeld beschreibt, umfassen. Anhand des (das Hauptmagnetfeld beschreibenden) zumindest einen Parameters, des zumindest einen Gradientenwertes und des (abgeschätzten) zumindest einen Abweichungswertes kann ein (tatsächliches) Gesamtmagnetfeld abgeschätzt, insbesondere berechnet, werden. Vorteilhafterweise umfasst das Gesamtmagnetfeld das Hauptmagnetfeld und das zumindest eine Ist-Gradientenmagnetfeld. Insbesondere werden zur Berechnung des Gesamtmagnetfeld die Vektorfelder des Hauptmagnetfeldes und des zumindest einen Ist-Gradientenmagnetfeldes vektoriell addiert.

Insbesondere kann das Gesamtmagnetfeld B(x,y,z) beschrieben werden durch:

$$\boldsymbol{B}(x,y,z) = \begin{bmatrix} \boldsymbol{i} & \boldsymbol{j} & \boldsymbol{k} \end{bmatrix} \cdot \begin{bmatrix} B_{0x}(x,y,z) + z \cdot GX - x\frac{GZ}{2} \\ B_{0y}(x,y,z) + z \cdot GY - y\frac{GZ}{2} \\ B_{0z}(x,y,z) + x \cdot GX + y \cdot GY + z \cdot GZ \end{bmatrix}$$

Dabei sind *i, j* und *k* Einheitsvektoren in X-Richtung, Y-Richtung und Z-Richtung. $B_{0x}(x,y,z)$ ist der ortsabhängige Betrag und/oder die Stärke des Hauptmagnetfeldes $\boldsymbol{B_0}(x,y,z)$ in X-Richtung, $\boldsymbol{B_{0y}}(x,y,z)$ ist der ortsabhängige Betrag und/oder die Stärke des Hauptmagnetfeldes $\boldsymbol{B_0}(x,y,z)$ in Y-Richtung und $B_{0z}(x,y,z)$ ist der ortsabhängige Betrag und/oder die Stärke des Hauptmagnetfeldes $\boldsymbol{B_0}(x,y,z)$ in Z-Richtung.

Vorzugsweise wird, insbesondere mittels der Magnetresonanzvorrichtung, eine Magnetresonanzmessung durchgeführt, wobei vor der Magnetresonanzmessung der zumindest eine Parameter des Hauptmagnetfeldes kalibriert wurde, wobei während der Magnetresonanzmessung der kalibrierte zumindest eine Parameter, insbesondere in Echtzeit, rekalibriert wird, wobei die Abschätzung des Gesamtmagnetfeldes anhand des kalibrierten zumindest einen Parameter erfolgt. Vorteilhafterweise können durch die Rekalibrierung etwaige Driftartefakte in während der Magnetresonanzmessung erfassten Magnetresonanzabbildungen reduziert werden.

Die Kalibrierung des zumindest einen Parameter des Hauptmagnetfeldes kann beispielsweise mit Hilfe einer 3D-Magnetfeldkamera erfolgen. Die Rekalibrierung des zumindest einen Parameter des Hauptmagnetfeldes kann beispielsweise mit Hilfe zumindest einer Sensors, insbesondere eines Temperatursensors und/oder eines Vibrationssensors, erfolgen.

Ferner wird eine Systemsteuereinheit vorgeschlagen, die ausgebildet ist, ein vorab beschriebenes Verfahren zum Abschätzen zumindest eines Abweichungswertes auszuführen. Die Systemsteuereinheit kann insbesondere eine Recheneinheit mit einem oder mehreren Prozessoren und/oder ein oder mehrere Speichermodule umfassen.

Ferner wird eine Magnetresonanzvorrichtung mit einer Systemsteuereinheit vorgeschlagen, die ausgebildet ist, ein vorab beschriebenes Verfahren zum Abschätzen zumindest eines Abweichungswertes auszuführen.

Die Vorteile der vorgeschlagenen Systemsteuereinheit und/oder der Magnetresonanzvorrichtung entsprechen im Wesentlichen den Vorteilen des erfindungsgemäßen Verfahrens zum Abschätzen zumindest eines Abweichungswertes, welche vorab im Detail ausgeführt sind. Hierbei erwähnte Merkmale, Vorteile oder alternative Ausführungsformen können ebenso auch auf die anderen beanspruchten Gegenstände übertragen werden und umgekehrt.

Ferner wird ein Computerprogrammprodukt vorgeschlagen, das ein Programm umfasst und direkt in einen Speicher einer programmierbaren Systemsteuereinheit einer Magnetresonanzvorrichtung ladbar ist und Programmmittel, z.B. Bibliotheken und Hilfsfunktionen, aufweist, um ein erfindungsgemäßes Verfahren auszuführen, wenn das Computerprogrammprodukt in der Systemsteuereinheit der Magnetresonanzvorrichtung ausgeführt wird. Das Computerprogrammprodukt kann dabei eine Software mit einen Quellcode, der noch kompiliert und gebunden oder der nur interpretiert werden muss, oder einen ausführbaren Softwarecode umfassen, der zur Ausführung nur noch in die Systemsteuereinheit zu laden ist. Durch das Computerprogrammprodukt kann das erfindungsgemäße Verfahren schnell, identisch wiederholbar und robust ausgeführt werden.

Das Computerprogrammprodukt ist so konfiguriert, dass es mittels der Systemsteuereinheit die erfindungsgemäßen Verfahrensschritte ausführen kann. Die Systemsteuereinheit muss dabei jeweils die Voraussetzungen wie beispielsweise einen entsprechenden Arbeitsspeicher, eine entsprechende Grafikkarte oder eine entsprechende Logikeinheit aufweisen, so dass die jeweiligen Verfahrensschritte effizient ausgeführt werden können. Das Computerprogrammprodukt ist beispielsweise auf einem computerlesbaren Medium gespeichert oder auf einem Netzwerk oder Server hinterlegt, von wo es in den Prozessor einer lokalen Systemsteuereinheit geladen werden kann, der mit der Magnetresonanzvorrichtung direkt verbunden oder als Teil der Magnetresonanzvorrichtung ausgebildet sein kann.

Weiterhin können Steuerinformationen des Computerprogrammprodukts auf einem elektronisch lesbaren Datenträger gespeichert sein. Die Steuerinformationen des elektronisch lesbaren Datenträgers können derart ausgestaltet sein, dass sie bei Verwendung des Datenträgers in einer Systemsteuereinheit einer Magnetresonanzvorrichtung ein erfindungsgemäßes Verfahren durchführen. Beispiele für elektronische lesbare Datenträger sind eine DVD, ein Magnetband oder einen USB-Stick, auf welchem elektronisch lesbare Steuerinformationen, insbesondere Software, gespeichert ist. Wenn diese Steuerinformationen von dem Datenträger gelesen und in eine Systemsteuereinheit der Magnetresonanzvorrichtung gespeichert werden, können alle erfindungsgemäßen Ausführungsformen der vorab beschriebenen Verfahren durchgeführt werden. So kann die Erfindung auch von dem besagten computerlesbaren Medium und/oder dem besagten elektronisch lesbaren Datenträger ausgehen.

Weitere Vorteile, Merkmale und Einzelheiten der Erfindung ergeben sich aus den im Folgenden beschriebenen Ausführungsbeispielen sowie anhand der Zeichnungen. Einander entsprechende Teile sind in allen Figuren mit den gleichen Bezugszeichen versehen.

Es zeigen:

Fig. 1        eine Magnetresonanzvorrichtung in einer schematischen Darstellung,

Fig. 2        Teileinheiten einer Gradientenspuleneinheit einer Magnetresonanzvorrichtung,

Fig. 3        ein Ablaufdiagramm eines Verfahrens zum Abschätzen zumindest eines Abweichungswertes,

Fig. 4-10     den Einfluss von Maxwell-Termen darstellende magnetische Vektorfelder,

Fig. 11       eine Addition verschiedener Magnetfeldquellen, insbesondere Beiträge zum gesamten Magnetfeld.

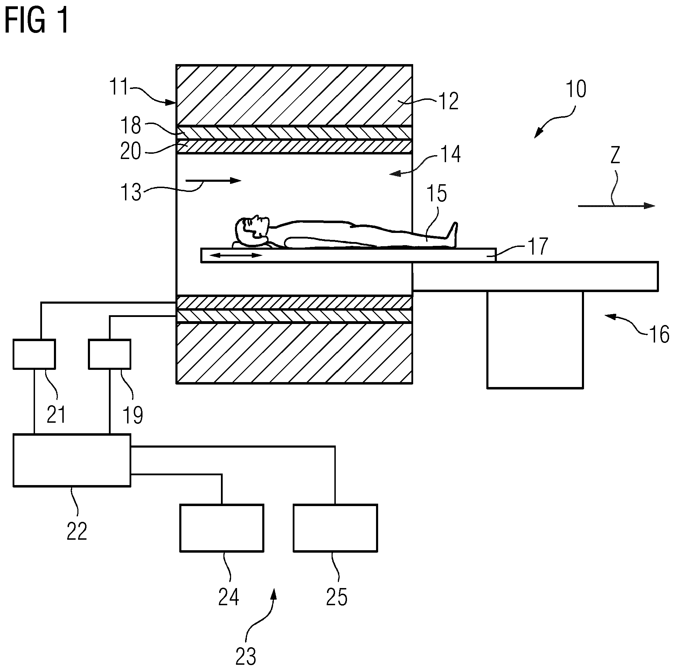

In Fig. 1 ist eine Magnetresonanzvorrichtung 10 schematisch dargestellt. Die Magnetresonanzvorrichtung 10 umfasst eine Magneteinheit 11, die einen Hauptmagneten 12 zu einem Erzeugen eines starken und insbesondere zeitlich konstanten Hauptmagnetfeldes $B_0$ aufweist. Zudem umfasst die Magnetresonanzvorrichtung 10 einen Patientenaufnahmebereich 14 zu einer Aufnahme eines Patienten 15. Der Patientenaufnahmebereich 14 im vorliegenden Ausführungsbeispiel ist zylinderförmig ausgebildet und in einer Umfangsrichtung von der Magneteinheit 11 zylinderförmig umgeben. Parallel zur Richtung des Hauptmagnetfeldes $B_0$, der Hauptmagnetfeldrichtung 13, verläuft die Zylinderachse des Patientenaufnahmebereichs 14, die Z-Achse in der Raumrichtung Z. Der Patient 15 kann mittels einer Patientenlagerungsvorrichtung 16 der Magnetresonanzvorrichtung 10 in den Patientenaufnahmebereich 14 geschoben werden. Die Patientenlagerungsvorrichtung 16 weist hierzu einen innerhalb des Patientenaufnahmebereichs 14 bewegbar ausgestalteten Patiententisch 17 auf.

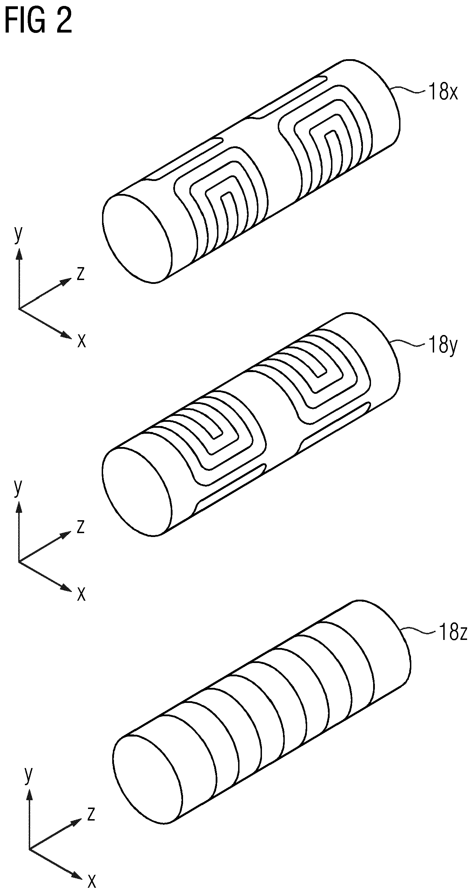

Die Magneteinheit 11 weist weiterhin eine Gradientenspuleneinheit 18 (mit mehreren in Fig. 2 dargestellten Gradientenspulen) zu einer Erzeugung von Gradientenmagnetfeldern, insbesondere von Ist-Gradientenmagnetfeldern, auf, die sich mit dem Hauptmagnetfeld $B_0$ überlagern und für eine Ortskodierung während einer Bildgebung verwendet werden. Die Gradientenspuleneinheit 18 wird mittels einer Gradientensteuereinheit 19 der Magnetresonanzvorrichtung 10 gesteuert. Die Magneteinheit 11 umfasst weiterhin eine Hochfrequenzantenneneinheit 20, welche im vorliegenden Ausführungsbeispiel als fest in die Magnetresonanzvorrichtung 10 integrierte Körperspule ausgebildet ist. Die Hochfrequenzantenneneinheit 20 wird von einer Hochfrequenzantennensteuereinheit 21 der Magnetresonanzvorrichtung 10 gesteuert und strahlt hochfrequente Magnetresonanzsequenzen in einen Untersuchungsraum ein, der im Wesentlichen von einem Patientenaufnahmebereich 14 der Magnetresonanzvorrichtung 10 gebildet ist. Dadurch stellt sich dem von dem Hauptmagneten 12 erzeugten Hauptmagnetfeld 13 eine Anregung von Atomkernen ein. Durch Relaxation der angeregten Atomkerne werden Magnetresonanzsignale erzeugt. Die Hochfrequenzantenneneinheit 20 ist zum Empfang der Magnetresonanzsignale ausgebildet.

Zu einer Steuerung des Hauptmagneten 12, der Gradientensteuereinheit 19 und zur Steuerung der Hochfrequenzantennensteuereinheit 21 weist die Magnetresonanzvorrichtung 10 eine Systemsteuereinheit 22 auf. Die Systemsteuereinheit 22 steuert zentral die Magnetresonanzvorrichtung 10, wie beispielsweise das Durchführen einer vorbestimmten bildgebenden Gradientenechosequenz. Zudem umfasst die Systemsteuereinheit 22 eine nicht näher dargestellte Auswerteeinheit zu einer Auswertung der Magnetresonanzsignale, die während der Magnetresonanzuntersuchung erfasst werden. Des Weiteren umfasst die Magnetresonanzvorrichtung 10 eine Benutzerschnittstelle 23, die mit der Systemsteuereinheit 22 verbunden ist. Steuerinformationen wie beispielsweise Bildgebungsparameter, sowie rekonstruierte Magnetresonanzabbildungen können auf einer Anzeigeeinheit 24, beispielsweise auf zumindest einem Monitor, der Benutzerschnittstelle 23 für ein medizinisches Bedienpersonal angezeigt werden. Weiterhin weist die Benutzerschnittstelle 23 eine Eingabeeinheit 25 auf, mittels der Informationen und/oder Parameter während eines Messvorgangs von dem medizinischen Bedienpersonal eingegeben werden können.

Fig. 2 zeigt drei Gradientenspulen 18x, 18y, 18z der Gradientenspuleneinheit 18. Die Gradientenspule 18x, XGC, erzeugt ein Gradientenmagnetfeld, insbesondere ein Ist-Gradientenmagnetfeld, mit einem Gradienten des Betrags des Magnetfeldes in X-Richtung. Die Gradientenspule 18y, YGC, erzeugt ein Gradientenmagnetfeld, insbesondere ein Ist-Gradientenmagnetfeld, mit einem Gradienten des Betrags des Magnetfeldes in Y-Richtung. Die Gradientenspule 18z, ZGC, erzeugt ein Gradientenmagnetfeld, insbesondere ein Ist-Gradientenmagnetfeld, mit einem Gradienten des Betrags des Magnetfeldes in Z-Richtung. Die Vektorfelder $B_{qx}(x,y,z)$, $B_{gy}(x,y,z)$ $B_{gz}(x,y,z)$ der drei Gradientenmagnetfelder, insbesondere der zugehörigen Soll-Gradientenmagnetfelder, sind idealerweise (nur) in Z-Richtung orientiert; Abweichungen von dieser idealen Feldrichtung können insbesondere mit dem vorgeschlagenen Verfahren abgeschätzt und/oder berücksichtigt werden.

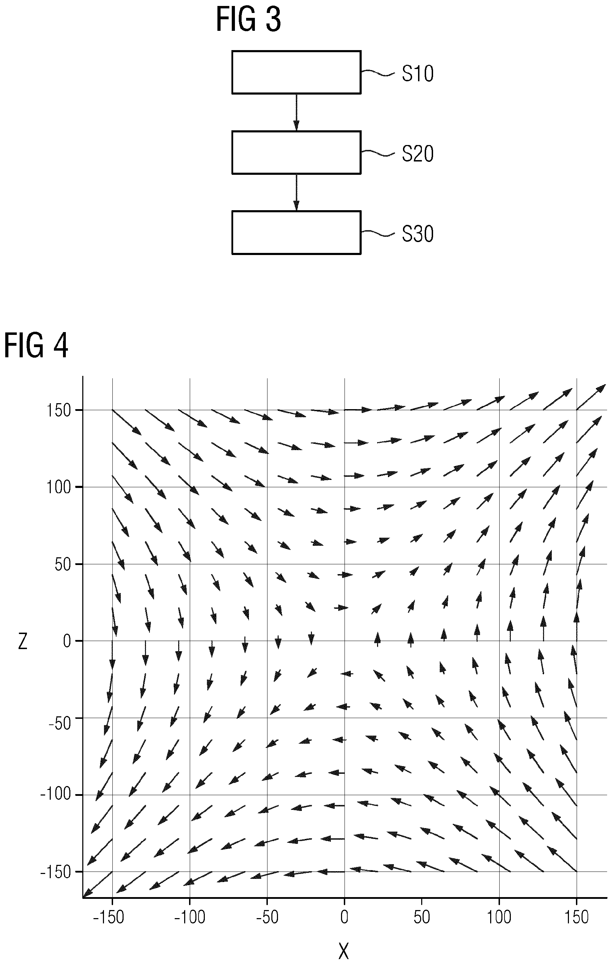

Die Magnetresonanzvorrichtung 10, insbesondere die Systemsteuereinheit 22, ist ausgebildet, ein in Fig. 3 dargestelltes computerimplementiertes Verfahren zum Abschätzen zumindest eines Abweichungswertes, insbesondere eines Maxwell-Terms, durchzuführen. Der zumindest eine Abweichungswert beschreibt eine Abweichung eines Ist-Gradientenmagnetfeldes von einem Soll-Gradientenmagnetfeld der Magnetresonanzvorrichtung.

In S10 wird zumindest ein Gradientenwertes, beispielsweise die Gradientenwerte GX, GY, GZ, bereitgestellt. Jeder der Gradientenwerte GX, GY, GZ beschreibt eine Gradientenstärke des jeweiligen Gradientenmagnetfeldes, insbesondere des Ist-Gradientenmagnetfeldes und/oder der zugehörigen Soll-Gradientenmagnetfeldes.

In S20 wird zumindest ein Abweichungswertes abgeschätzt, indem die Gradientenwerte GX, GY, GZ auf ein Magnetfeldmodell abgewendet werden. Gemäß dem Magnetfeldmodell wird die Abweichung des Ist-Gradientenmagnetfeldes von dem Soll-Gradientenmagnetfeld durch zumindest eine vektorielle Komponente in einer von der Hauptmagnetfeldrichtung Z abweichenden Raumrichtung X, Y beschrieben wird.

Optional erfolgt in S30 unter Berücksichtigung des abgeschätzten zumindest ein Abweichungswertes eine Akquisition und/oder Rekonstruktion von Magnetresonanzsignalen.

Im Folgenden sollen verschiedene mögliche Merkmale und Vorteile des Verfahrens zur Abschätzung des zumindest einen Abweichungswertes dargestellt werden. Mit dem Verfahren können insbesondere folgende Aspekte gegenüber dem Stand der Technik verbessert werden:

    a. Es kann nicht nur der Betrag bzw. die Stärke des Magnetfeldes, insbesondere des zumindest einen Ist-Gradientenmagnetfeldes, abgeschätzt werden, sondern auch seine Richtung.

    b. Es können für jede kartesische Achse Abweichungen des Feldes separat abgeschätzt werden abhängig davon, welche Gradientenspule aktiv ist.

    c. Es kann eine Abschätzung durchgeführt werden, die nicht voraussetzt, dass das Hauptmagnetfeld $B_0(x,y,z)$

homogen ist (vgl. Annahme A4 der Bernstein-Methode).

d. Es müssen keine Annahmen über die Feldstärke getroffen werden (vgl. Annahme A5 der Bernstein-Methode). Dadurch können insbesondere auch Abschätzungen für niedrige Stärken des Hauptmagnetfeldes (beispielsweise $B_0 \leq 0.5$ T) und recht hohe Gradientenstärken (beispielsweise $G_{max} \geq 40$ mT/m) durchgeführt werden. Das Verfahren kann ferner angewendet werden auf hohe Stärken des Hauptmagnetfeldes mit sehr hohen Gradientenstärken, beispielsweise $B_0$ = 3T, $G_{max}$ = 300mT/m.

Ein besonders großer möglicher Vorteil des vorgeschlagenen Verfahrens besteht darin, dass eine Taylorreihenentwicklung nicht mehr notwendig ist, so dass hier keine zusätzlichen vereinfachende Annahmen getroffen werden müssen, indem Terme höherer Ordnung der Taylorreihe ignoriert werden. Ferner besteht ein großer möglicher Vorteil darin, dass durch eine selektive Anwendung des Verfahrens in Abhängigkeit der aktiven Gradientenspulen bewusst Unzulänglichkeiten verschiedener konventioneller Annahmen (vgl. Annahmen A1 ... A5 der Bernstein-Methode) berücksichtigt werden können.

## 1. Mathematische Grundlagen

Seien A(x,y,z) and $B(x,y,z)$ zwei Vektorfelder. Für Rotationsund Divergenz-Operator gilt das Assoziativgesetz:

$$\nabla \times (\boldsymbol{A} + \boldsymbol{B}) = \nabla \times \boldsymbol{A} + \nabla \times \boldsymbol{B}$$

$$\nabla \cdot (\boldsymbol{A} + \boldsymbol{B}) = \nabla \cdot \boldsymbol{A} + \nabla \cdot \boldsymbol{B}$$

## 2. Physikalische Grundlagen

Innerhalb des FOV der Magnetresonanzvorrichtung sind Verschiebungsströme und Konvektionsströme (echte Leitungsströme) vernachlässigbar. Somit ergibt sich aus den Maxwell-Gleichungen, dass das magnetische Vektorfeld B innerhalb des FOV wirbelfrei und quellfrei ist:

$$\begin{cases} \nabla \times \boldsymbol{B} = \mu_0 \boldsymbol{J} + \dfrac{1}{c^2}\dfrac{\partial \boldsymbol{E}}{\partial t} = 0 \\[2em] \nabla \cdot \boldsymbol{B} = 0 \end{cases}$$

Damit gelten für die kartesischen Komponenten $B_x$, $B_y$ and $B_z$ des Vektorfeldes B folgende Beziehungen:

$$\nabla \times \boldsymbol{B} = \begin{vmatrix} \boldsymbol{i} & \boldsymbol{j} & \boldsymbol{k} \\ \dfrac{\partial}{\partial x} & \dfrac{\partial}{\partial y} & \dfrac{\partial}{\partial z} \\ B_x & B_y & B_z \end{vmatrix} = 0 \rightarrow \frac{\partial B_x}{\partial z} = \frac{\partial B_z}{\partial x}, \quad \frac{\partial B_y}{\partial x} = \frac{\partial B_x}{\partial y}, \quad \frac{\partial B_z}{\partial y} = \frac{\partial B_y}{\partial z}$$

$$\nabla \cdot \boldsymbol{B} = 0 \rightarrow \frac{\partial B_x}{\partial x} + \frac{\partial B_y}{\partial y} + \frac{\partial B_z}{\partial z} = 0$$

Das gesamte Vektorfeld $B(x,y,z)$ im Bildgebungsvolumen resultiert aus einer Überlagerung des Hauptmagnetfeldes $B_0(x,y,z)$ (erzeugt durch den Hauptmagneten 11) und den Ist-Gradientenmagnetfeldern $B_{gx}(x,y,z)$, $B_{gy}(x,y,z)$ und/oder $B_{gz}(x,y,z)$ (erzeugt durch die Gradientenspulen 18x, 18y, 18z der Gradientenspuleneinheit 18). Da die Quellen der sich überlagernden Magnetfelder, also des Hauptmagnetfeldes und des zumindest einen Ist-Gradientenmagnetfeldes, nicht miteinander wechselwirken und etwaige durch Wirbelströme verursachte Transienteneffekte vernachlässigt werden können, ergibt sich beispielsweise für eine Überlagerung des Hauptmagnetfeldes $B_0$ und eines Ist-Gradientenmagnetfeldes $B_{gx}(x,y,z)$ in X-Richtung:

$$\begin{cases} \nabla \times \left(\boldsymbol{B}_0 + \boldsymbol{B}_{gx}\right) = \nabla \times \boldsymbol{B}_0 + \nabla \times \boldsymbol{B}_{gx} = 0 + 0 \\[2mm] \nabla \cdot \left(\boldsymbol{B}_0 + \boldsymbol{B}_{gx}\right) = \nabla \cdot \boldsymbol{B}_0 + \nabla \cdot \boldsymbol{B}_{gx} = 0 + 0 \end{cases}$$

Daraus schließt der Erfinder, dass für den Fall, dass zwei oder mehrere Gradientenspulen aktiv sind, diese Gleichungen auf alle möglichen Überlagerungen von Magnetfeldern ausgedehnt werden können; jeder einzelner Beitrag zum gesamten Magnetfeld $\boldsymbol{B}(x,y,z)$ im Bildgebungsvolumen (z.B. jedes Ist-Gradientenmagnetfeld $\boldsymbol{B}_{gx}(x,y,z)$, $\boldsymbol{B}_{gy}(x,y,z)$ und/oder $\boldsymbol{B}_{gz}(x,y,z)$ und/oder das Hauptmagnetfeld $\boldsymbol{B}_0(x,y,z)$) ist also wirbelfrei und quellfrei. Diese wichtige erfinderische Erkenntnis ermöglicht eine unabhängige Betrachtung jedes Magnetfeldbeitrags, woraus verschiedene technische Vorteile abgeleitet werden können, wie im Folgenden gezeigt wird.

**3. Abschätzung von Maxwell-Termen bei aktiver Gradientenspule 18x zur Erzeugung eines Magnetfeldgradienten in X-Richtung**

Bei Verwendung der Ausdrücke aus Abschnitt 2 für die kartesischen Komponenten des Ist-Gradientenmagnetfeldes $\boldsymbol{B}_{gx}(x,y,z)$ und den Annahmen A1 bis A3 ergibt sich für die vektoriellen Komponenten $B_{gx,x}$, $B_{gx,y}$ und $B_{gx,z}$:

$$B_{gx,z} = x \cdot GX \rightarrow \begin{cases} \dfrac{\partial B_{gx,z}}{\partial x} = GX \\[2mm] \dfrac{\partial B_{gx,z}}{\partial y} = 0 \\[2mm] \dfrac{\partial B_{gx,z}}{\partial z} = 0 \end{cases} \rightarrow \begin{cases} \begin{cases} \dfrac{\partial B_{gx,x}}{\partial x} = \dfrac{\partial B_{gx,y}}{\partial y} = 0 \\[2mm] \dfrac{\partial B_{gx,x}}{\partial y} = \dfrac{\partial B_{gx,y}}{\partial x} = 0 \\[2mm] \dfrac{\partial B_{gx,x}}{\partial z} = \dfrac{\partial B_{gx,z}}{\partial x} = GX \end{cases} \rightarrow B_{gx,x} = z \cdot GX \\[6mm] \begin{cases} \dfrac{\partial B_{gx,y}}{\partial x} = \dfrac{\partial B_{gx,x}}{\partial y} = 0 \\[2mm] \dfrac{\partial B_{gx,y}}{\partial y} = \dfrac{\partial B_{gx,x}}{\partial x} = 0 \\[2mm] \dfrac{\partial B_{gx,y}}{\partial z} = \dfrac{\partial B_{gx,z}}{\partial y} = 0 \end{cases} \rightarrow B_{gx,y} = 0 \end{cases}$$

Die Abweichung des Ist-Gradientenmagnetfeldes von dem Soll-Gradientenmagnetfeld werden hier durch die vektoriellen Komponenten $B_{gx,x}$ und $B_{gx,y}$ der von der Hauptmagnetfeldrichtung (Z-Richtung) abweichenden Raumrichtungen (X- und Y-Richtung) beschrieben. Eine Gradientenspule 18x zur Erzeugung eines in Z-Richtung orientierten Magnetfeldes mit einem linearen Magnetfeldgradienten in X-Richtung erzeugt also ein ebenso großes, begleitendes orthogonales Magnetfeld, das in X-Richtung orientiert ist und sich linear mit der z-Koordinate ändert. Die vektorielle Komponente $B_{gx,x}$ weist eine lineare Abhängigkeit von der z-Koordinate auf. Hingegen ist das in Y-Richtung orientierte begleitende orthogonale Magnetfeld vernachlässigbar klein bzw. näherungsweise 0.

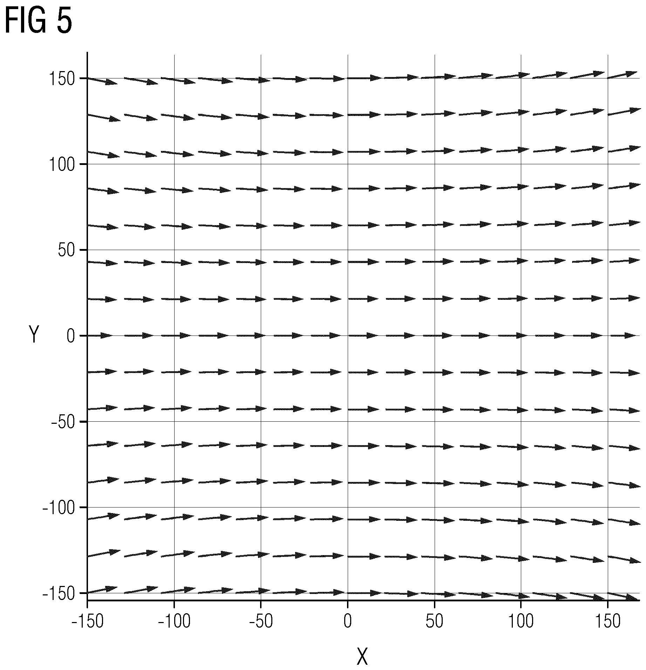

In Fig. 4 und 5 sind beispielhaft ein Magnetfeld $\boldsymbol{B}(x,y,z)$ jeweils als Vektorfeld dargestellt, welche die Gültigkeit der obigen theoretischen Ergebnisse bestätigen. In Fig. 4 gilt $y = 0$ und in Fig. 5 $z = z_0 > 0$. Während sich in Fig. 4 die X-Komponente der Vektoren abhängig von der z-Koordinate signifikant ändert, ist in Fig. 5 die Y-Komponente der Vektoren auch bei $z = z_0 > 0$ vernachlässigbar.

**4. Abschätzung von Maxwell-Termen bei aktiver Gradientenspule 18y zur Erzeugung eines Magnetfeldgradienten in Y-Richtung**

Bei Verwendung der Ausdrücke aus Abschnitt 2 für die kartesischen Komponenten des Ist-Gradientenmagnetfeldes $\boldsymbol{B}_{gy}(x,y,z)$ und den Annahmen A1 bis A3 ergibt sich für die vektoriellen Komponenten $B_{gy,x}$, $B_{gy,y}$ und $B_{gy,z}$:

$$B_{gy,z} = y \cdot GY \rightarrow \begin{cases} \dfrac{\partial B_{gy,z}}{\partial x} = 0 \\[2mm] \dfrac{\partial B_{gy,z}}{\partial y} = GY \\[2mm] \dfrac{\partial B_{gy,z}}{\partial z} = 0 \end{cases} \rightarrow \begin{cases} \begin{cases} \dfrac{\partial B_{gy,x}}{\partial x} = \dfrac{\partial B_{gy,y}}{\partial y} = 0 \\[2mm] \dfrac{\partial B_{gy,x}}{\partial y} = \dfrac{\partial B_{gy,y}}{\partial x} = 0 \\[2mm] \dfrac{\partial B_{gy,x}}{\partial z} = \dfrac{\partial B_{gy,z}}{\partial x} = 0 \end{cases} \rightarrow B_{gy,x} = 0 \\[8mm] \begin{cases} \dfrac{\partial B_{gy,y}}{\partial x} = \dfrac{\partial B_{gy,x}}{\partial y} = 0 \\[2mm] \dfrac{\partial B_{gy,y}}{\partial y} = \dfrac{\partial B_{gy,x}}{\partial x} = 0 \\[2mm] \dfrac{\partial B_{gy,y}}{\partial z} = \dfrac{\partial B_{gy,z}}{\partial y} = GY \end{cases} \rightarrow B_{gy,y} = z \cdot GY \end{cases}$$

Die Abweichung des Ist-Gradientenmagnetfeldes von dem Soll-Gradientenmagnetfeld werden hier durch die vektoriellen Komponenten $B_{gy,x}$ und $B_{gy,y}$ der von der Hauptmagnetfeldrichtung (Z-Richtung) abweichenden Raumrichtungen (X- und Y-Richtung) beschrieben. Eine Gradientenspule 18y zur Erzeugung eines in Z-Richtung orientierten Magnetfeldes mit einem linearen Magnetfeldgradienten in Y-Richtung erzeugt also ein ebenso großes, begleitendes orthogonales Magnetfeld, das in Y-Richtung orientiert ist und sich linear mit der z-Koordinate ändert. Die vektorielle Komponente $B_{gy,y}$ weist eine lineare Abhängigkeit von der z-Koordinate auf. Hingegen ist das in X-Richtung orientierte begleitende orthogonale Magnetfeld vernachlässigbar klein bzw. näherungsweise 0.

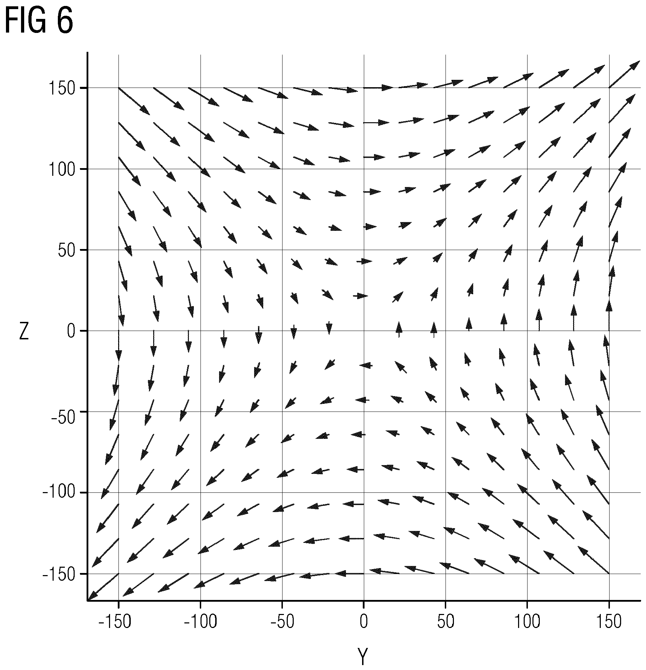

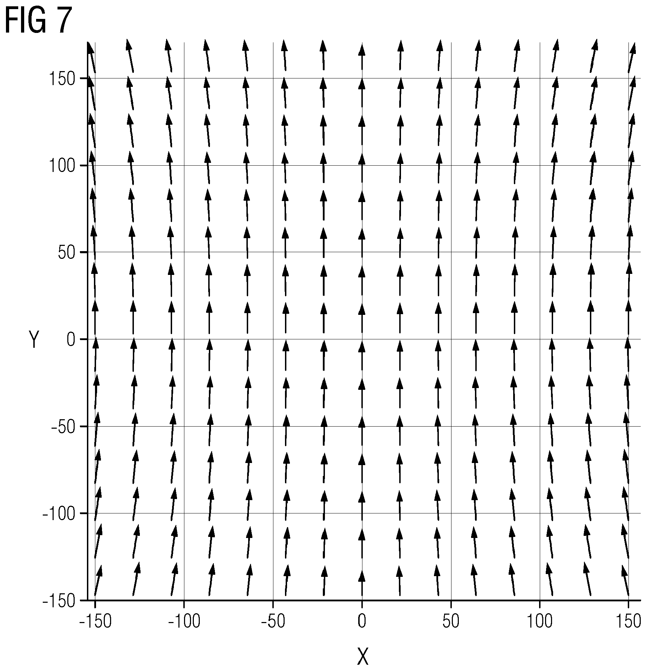

In Fig. 6 und 7 sind beispielhaft ein Magnetfeld $\boldsymbol{B}(x,y,z)$ jeweils als Vektorfeld dargestellt, welche die Gültigkeit der obigen theoretischen Ergebnisse bestätigen. In Fig. 6 gilt $x = 0$ und in Fig. 7 $z = z_0 > 0$. Während sich in Fig. 6 die Y-Komponente der Vektoren abhängig von der z-Koordinate signifikant ändert, ist in Fig. 7 die X-Komponente der Vektoren auch bei $z = z_0 > 0$ vernachlässigbar.

### 5. Abschätzung von Maxwell-Termen bei aktiver Gradientenspule 18z zur Erzeugung eines Magnetfeldgradienten in Z-Richtung

Bei Verwendung der Ausdrücke aus Abschnitt 2 für die kartesischen Komponenten des Ist-Gradientenmagnetfeldes $B_{gz}(x,y,z)$ und den Annahmen A1 bis A3 ergibt sich für die vektoriellen Komponenten $B_{gz,x}$, $B_{gz,y}$ und $B_{gz,z}$:

$$B_{gz,z} = z \cdot GZ \rightarrow \begin{cases} \dfrac{\partial B_{gz,z}}{\partial x} = 0 \\[2mm] \dfrac{\partial B_{gz,z}}{\partial y} = 0 \\[2mm] \dfrac{\partial B_{gz,z}}{\partial z} = GZ \end{cases} \rightarrow \begin{cases} \begin{cases} \dfrac{\partial B_{gz,x}}{\partial x} = \dfrac{\partial B_{gz,y}}{\partial y} = -\dfrac{GZ}{2} \\[2mm] \dfrac{\partial B_{gz,x}}{\partial y} = \dfrac{\partial B_{gz,y}}{\partial x} = 0 \\[2mm] \dfrac{\partial B_{gz,x}}{\partial z} = \dfrac{\partial B_{gz,z}}{\partial x} = 0 \end{cases} \rightarrow B_{gz,x} = -x\dfrac{GZ}{2} \\[8mm] \begin{cases} \dfrac{\partial B_{gz,y}}{\partial x} = \dfrac{\partial B_{gz,x}}{\partial y} = 0 \\[2mm] \dfrac{\partial B_{gz,y}}{\partial y} = \dfrac{\partial B_{gz,x}}{\partial x} = -\dfrac{GZ}{2} \\[2mm] \dfrac{\partial B_{gz,y}}{\partial z} = \dfrac{\partial B_{gz,z}}{\partial y} = 0 \end{cases} \rightarrow B_{gz,y} = -y\dfrac{GZ}{2} \end{cases}$$

Die Abweichung des Ist-Gradientenmagnetfeldes von dem Soll-Gradientenmagnetfeld werden hier durch die vektoriellen Komponenten $B_{gz,x}$ und $B_{gz,y}$ der von der Hauptmagnetfeldrichtung (Z-Richtung) abweichenden Raumrichtungen (X- und Y-Richtung) beschrieben. Eine Gradientenspule 18z zur Erzeugung eines in z-Richtung orientierten Magnetfeldes mit einem linearen Magnetfeldgradienten in Z-Richtung erzeugt also zwei halb so große, begleitendes orthogonales Magnetfelder: das eine ist entgegengesetzt zur *X*-Richtung orientiert ist und ändert sich linear mit der x-Koordinate; das andere ist entgegengesetzt zur *Y*-Richtung orientiert ist und ändert sich linear mit der *y*-Koordinate. Die vektorielle Komponente $B_{gz,x}$ weist eine lineare Abhängigkeit von der *x*-Koordinate auf; die vektorielle Komponente $B_{gz,y}$ weist eine lineare Abhängigkeit von der *y*-Koordinate auf.

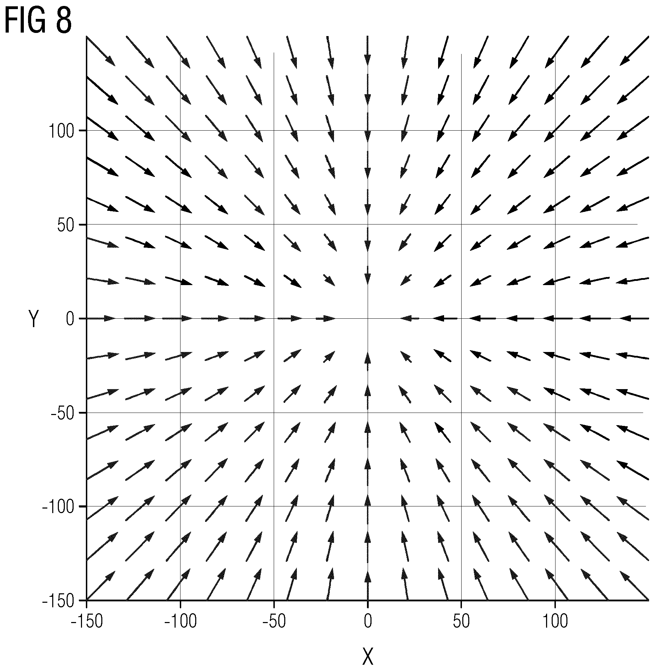

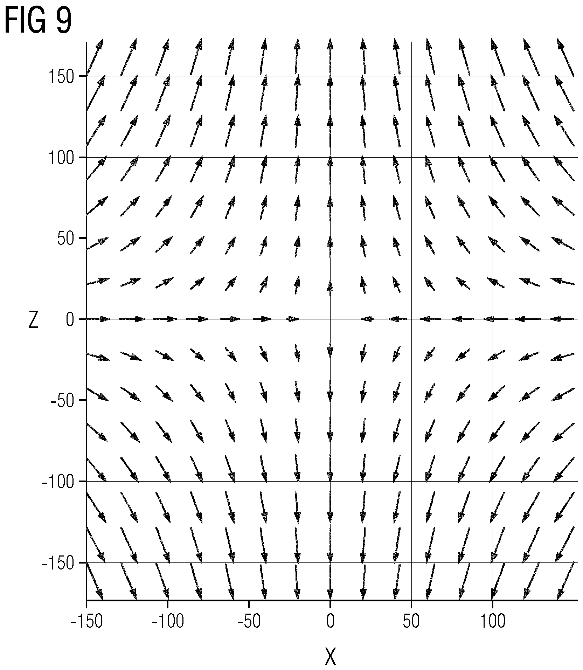

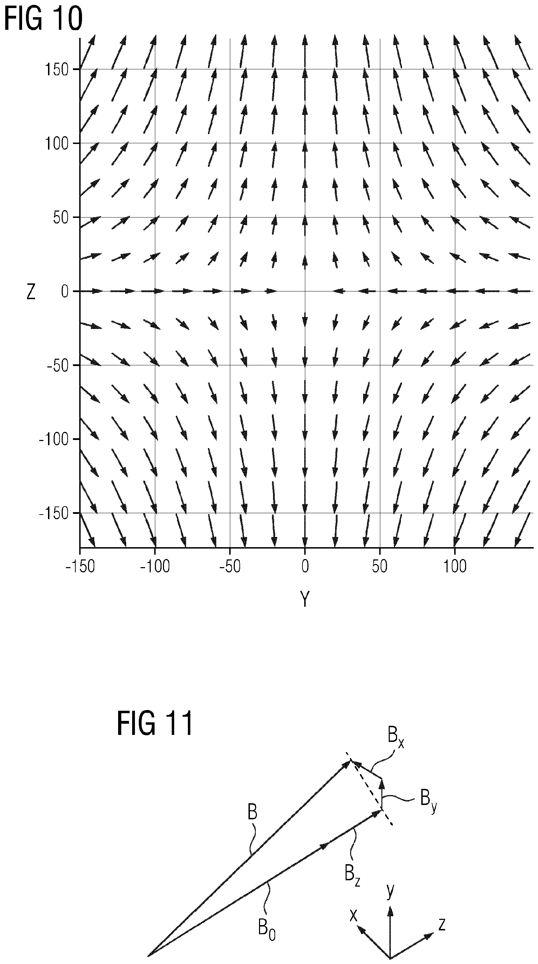

In Fig. 8-10 sind beispielhaft ein Magnetfeld $\boldsymbol{B}(x,y,z)$ jeweils als Vektorfeld dargestellt, welche die Gültigkeit der obigen theoretischen Ergebnisse bestätigen. In Fig. 8 gilt z = 0, in Fig. 9 gilt y = 0, und in Fig. 10 gilt x = 0.

### 6. Zusammenfassung der Abschätzungen der Maxwell-Terme

Gemäß den Ausführungen der Abschnitte 1-6 lässt sich festhalten, dass der Erfinder ein Magnetfeldmodell entwickelt hat, gemäß dem die Abweichung des Ist-Gradientenmagnetfeldes von dem Soll-Gradientenmagnetfeld durch zumindest eine vektorielle Komponente in einer von der Hauptmagnetfeldrichtung abweichenden Raumrichtung beschrieben wird.

Je nachdem, welche der Gradientenspulen 18x, 18y, 18z aktiv ist, umfasst das (resultierende) Gradientenmagnetfeld ein erstes Ist-Gradientenmagnetfeld mit einem Magnetfeldgradienten in der X-Richtung, ein zweites Ist-Gradientenmagnetfeld mit einem Magnetfeldgradienten in der Y-Richtung und/oder ein drittes Ist-Gradientenmagnetfeld mit einem Magnetfeldgradienten in der Z-Richtung. X-Richtung, Y-Richtung und Z-Richtung sind dabei orthogonal zueinander.

Das Vektorfeld des Hauptmagnetfeldes ist in der Hauptmagnetfeldrichtung, der Z-Richtung, ausgerichtet. Das Vektorfeld des ersten Ist-Gradientenmagnetfeldes weist die Vektoren $\boldsymbol{B}_{gx}(x,y,z)$ mit den Vektorkomponenten $B_{gx,x}$, $B_{gx,y}$ und $B_{gx,z}$ auf. Das Vektorfeld des zweiten Ist-Gradientenmagnetfeldes weist die Vektoren $\boldsymbol{B}_{gy}(x,y,z)$ mit den Vektorkomponenten $B_{gy,x}$, $B_{gy,y}$ und $B_{gy,z}$ auf. Das Vektorfeld des dritten Ist-Gradientenmagnetfeldes weist die Vektoren $\boldsymbol{B}_{gz}(x,y,z)$ mit den Vektorkomponenten $B_{gz,x}$, $B_{gz,y}$ und $B_{gz,z}$ auf. Die Vektorkomponenten $B_{gx,x}$, $B_{gx,y}$, $B_{gy,x}$, $B_{gy,y}$, $B_{gz,x}$ und $B_{gz,y}$ können als Abweichungswerte, insbesondere begleitende Feldkomponenten, aufgefasst werden, die eine Abweichung des Ist-Gradientenmagnetfeldes von einem Soll-Gradientenmagnetfeld der Magnetresonanzvorrichtung 10 beschreiben. Das Soll-Gradientenmagnetfeld kann insbesondere vorsehen, dass die Vektorkomponenten $B_{gx,x}$, $B_{gx,y}$, $B_{gy,x}$, $B_{gy,y}$, $B_{gz,x}$ und $B_{gz,y}$ gleich Null sind. Gemäß Abschnitt 4 und 5 ist dies insbesondere für $B_{gx,x}$, $B_{gy,y}$, $B_{gz,x}$ und $B_{gz,y}$ nicht der Fall.

### 7. Berechnung von durch Maxwell-Terme verursachten Feldfehlern bei homogenem Hauptmagnetfeld

Fig. 11 zeigt beispielhaft eine Überlagerung verschiedener Magnetfelder, indem Vektorkomponenten zu einem resultierenden Magnetfeld kombiniert, insbesondere addiert, werden. Dabei ist $\boldsymbol{B}_0$ der Vektor des Hauptmagnetfeldes, das durch den Hauptmagneten 12 erzeugt wird. $B_z$ ist die gewünschte (Soll-)Komponente des Gradientenmagnetfeld entlang der Z-Achse. $B_x$ und $B_y$ sind begleitende Feldkomponenten entlang der X- und Y-Achse. Falls mehrere Gradientenspulen gleichzeitig aktiv sind, können diese begleitende Feldkomponenten aus einer Summe mehrere begleitende Feldkomponenten resultieren, z.B. $B_x = B_{gx,x} + B_{gy,x} + B_{gz,x}$ und $B_y = B_{gx,y} + B_{gy,y} + B_{gz,y}$.

Insbesondere wenn der Hauptmagnet 12 gut geshimmt ist, kann das Hauptmagnetfeld $\boldsymbol{B}_0$ innerhalb des FOV eine sehr hohe Homogenität von nur wenigen ppm Abweichung von einem Zielwert aufweisen. In diesem Fall hat der Vektor $\boldsymbol{B}_0$ des Hauptmagnetfeldes einen konstanten Betrag $B_0$ und ist parallel zur Z-Achse, d.h. $\boldsymbol{B}_0 = B_0 \cdot \boldsymbol{k}$, wobei $\boldsymbol{k}$ der Einheitsvektor in Z-Richtung ist. Durch Verwendung der Abschätzung gemäß der Abschnitte 3-5 resultiert für Vektorfeld $\boldsymbol{B}(x,y,z)$ des gesamte Magnetfeldfeldes:

$$\boldsymbol{B}(x,y,z) = B_x\boldsymbol{i} + B_y\boldsymbol{j} + (B_0 + B_z)\boldsymbol{k} =$$
$$= \left(z \cdot GX - x\frac{GZ}{2}\right)\boldsymbol{i} + \left(z \cdot GY - y\frac{GZ}{2}\right)\boldsymbol{j} + (B_0 + x \cdot GX + y \cdot GY + z \cdot GZ)\boldsymbol{k}$$

Dabei sind i und j die Einheitsvektoren in X- und Y-Richtung. Somit kann nach einem Bereitstellen eines Parameters, der das Hauptmagnetfeld beschreibt, wie etwas das Vektorfeld $\boldsymbol{B}_0$, das Gesamtmagnetfeld $\boldsymbol{B}(x,y,z)$ anhand des Vektorfeldes $\boldsymbol{B}_0$, der Gradientenwerte *GX, GY, GZ* und der begleitenden Feldkomponenten abgeschätzt werden.

Natürlich vereinfacht sich die letzte Gleichung, wenn nur eine oder zwei Gradientenspulen aktiv sind. Ist beispielsweise nur die Gradientenspule 18x zur Erzeugung eines Magnetfeldgradienten in X-Richtung aktiv, gilt *GY = GZ* = 0, und die resultierende räumliche Verteilung des vektoriellen Magnetfeldes kann mit folgender Gleichung abgeschätzt werden:

$$\boldsymbol{B}(x,y,z) = (z \cdot GX)\boldsymbol{i} + (B_0 + x \cdot GX)\boldsymbol{k}$$

Es ist ferner denkbar, anhand des abgeschätzten Vektorfeldes $\mathbf{B}(x,y,z)$ durch Maxwell-Terme induzierte Kodierfehler von Magnetresonanzsignalen zu korrigieren. Beispielsweise ist während einer Auslesephase die lokale Frequenz proportional abhängig vom Betrag von $\mathbf{B}(x,y,z)$ - und nicht etwa wie konventioneller Weise idealisiert betrachtet proportional abhängig von $BZ(x,y,z) = B_0 + x \cdot GX$. Die tatsächliche räumliche Verteilung der Frequenzkodierung für das lokale Magnetresonanzsignal ergibt sich in diesem Fall zu

$$\omega(\mathrm{x},\mathrm{y},\mathrm{z}) = \gamma \cdot |\mathbf{B}(\mathrm{x},\mathrm{y},\mathrm{z})| = \gamma \cdot \sqrt{(\mathrm{z}\cdot\mathrm{GX})^2 + (\mathrm{B}_0 + \mathrm{x}\cdot\mathrm{GX})^2}$$

Dabei ist $\omega(x,y,z)$ die lokale Larmorfrequenz und $\gamma$ das gyromagnetische Verhältnis des Kerns von Interesse, meist der Wasserprotonen. Außerdem kann dieser Ausdruck direkt verwendet werden, um die geometrischen Verzerrungen in den Magnetresonanzabbildungen zu korrigieren. Der Vorteil des neuen Verfahrens gegenüber dem Stand der Technik besteht insbesondere darin, dass keine Entwicklung in Taylorreihen und/oder Annahmen über die relative Stärke der Gradientenfelder (vgl. Annahme A5 der Maxwell-Methode) erforderlich sind. Damit funktioniert das Verfahren auch für Magnetresonanzuntersuchungen mit niedrigem oder sehr niedrigem Feld.
Es kann also anhand der abgeschätzten Abweichungswerte, insbesondere der begleitenden Feldkomponenten, eine Korrektur von Magnetresonanzsignalen, insbesondere von einer Kodierung von Magnetresonanzsignalen, durchgeführt werden. Insbesondere kann die Korrektur eine Berechnung einer Larmorfrequenz in Abhängigkeit der Abweichungswerte umfassen.

**8. Berechnung von durch Maxwell-Terme verursachten Feldfehlern bei inhomogenem Hauptmagnetfeld**

Insbesondere um kostengünstige Magnetresonanzvorrichtungen, insbesondere Hauptmagnete, herstellen zu können, können Kompromisse hinsichtlich der realisierbaren Homogenität des statischen Hauptmagnetfeldes $\mathbf{B}_0$ erforderlich sein. Das vorgeschlagene Verfahren ermöglicht, die Auswirkungen solcher Inhomogenitäten zu kalibrieren und/oder zu korrigieren, um etwaige damit verbundenen Bildartefakte zu minimieren.
Zur Erstellung von Feldkarten (engl. field map) eines inhomogenen statischen Magnetfeldes, wie das Hauptmagnetfeld $\mathbf{B}_0$ $(x,y,z)$, sind im Stand der Technik verschiedene Verfahren bekannt, z.B. mittels einer 3D-Magnetfeldkamera. Es ist möglich, Signalkodierungsfehler bei Vorliegen begleitender Felder mittels solche Feldkarten zu korrigieren.
Im allgemeinen Fall resultiert das Gesamtmagnetfeld $\mathbf{B}(x,y,z)$ aus einer Überlagerung aller beitragenden Feldquellen. Falls alle Gradientenspulen aktiv sind, kann gemäß den Ausführungen der Abschnitte 2-4 die tatsächliche Feldverteilung ausgedrückt werden mit:

$$\mathbf{B}(x,y,z) = \begin{bmatrix} \mathbf{i} & \mathbf{j} & \mathbf{k} \end{bmatrix} \cdot \begin{bmatrix} B_{0x}(x,y,z) + z\cdot GX - x\dfrac{GZ}{2} \\ B_{0y}(x,y,z) + z\cdot GY - y\dfrac{GZ}{2} \\ B_{0z}(x,y,z) + x\cdot GX + y\cdot GY + z\cdot GZ \end{bmatrix}$$

Dabei sind $B_{0x}(x,y,z)$, $B_{0y}(x,y,z)$, $B_{0z}(x,y,z)$ die Vektorkomponenten des Vektorfeldes $\mathbf{B}_0(x,y,z)$ des Hauptmagnetfeldes.
Dieser Ausdruck kann in bestimmten Situationen vereinfacht werden. Falls beispielsweise das Hauptmagnetfeld zwar inhomogen, aber dennoch halbwegs parallel zur Z-Achse ist und nur die X-Gradientenspule 18x aktiv ist, gilt:

$$\mathbf{B}(x,y,z) = \begin{bmatrix} \mathbf{i} & \mathbf{j} & \mathbf{k} \end{bmatrix} \cdot \begin{bmatrix} z\cdot GX \\ 0 \\ B_{0z}(x,y,z) + x\cdot GX \end{bmatrix}$$

Dementsprechend gilt für die räumliche Verteilung der Frequenzkodierung lokaler Magnetresonanzsignale:

$$\omega(x,y,z) = \gamma \cdot |\mathbf{B}(x,y,z)| = \gamma \cdot \sqrt{(z\cdot GX)^2 + [B_{0z}(x,y,z) + x\cdot GX]^2}$$

Vorteilhafterweise können mit dem vorgeschlagenen Verfahren auch größere Inhomogenitäten des Hauptmagnetfeldes berücksichtigt werden, wie sie oftmals gerade in der Peripherie des FOV auftreten.

### 9. Modellbasierte Bildrekonstruktion

Vorteilhafterweise kann eine Bildrekonstruktion gemäß dem vorgeschlagenen Magnetfeldmodell die Phasenfehler berücksichtigen, die durch die begleitenden Felder induziert werden. Mit diesem Modell kann im allgemeinsten Fall eine momentane Frequenz der Magnetresonanzsignale an einem gegebenen räumlichen Ort modelliert werden:

$$\omega(x,y,z,t) = \gamma \cdot |\boldsymbol{B}(x,y,z,t)| =$$

$$= \gamma \cdot \left| [\boldsymbol{i} \quad \boldsymbol{j} \quad \boldsymbol{k}] \cdot \begin{bmatrix} B_{0x}(x,y,z,t) + z \cdot GX(t) - x\dfrac{GZ(t)}{2} \\ B_{0y}(x,y,z,t) + z \cdot GY(t) - y\dfrac{GZ(t)}{2} \\ B_{0z}(x,y,z,t) + x \cdot GX(t) + y \cdot GY(t) + z \cdot GZ(t) \end{bmatrix} \right|$$

Dabei berücksichtigt $\boldsymbol{B}(x,y,z,t)$ vorteilhafterweise eine zeitliche Drift des Magnetfeldes, insbesondere des Hauptmagnetfeldes, beispielsweise aufgrund von Bodenschwingungen oder durch thermische Erwärmung verschiedener Komponenten der Magneteinheit 11 (z.B. Feldspulen, Shimeisen, Former oder Permanentmagnete). Diese Drift kann beispielsweise vorab vorkalibriert werden, z.B. mittels einer 3D-Magnetfeldkamera, und während einer Magnetresonanzmessung rekalibriert werden, z.B. mittels eines oder mehreren Sensoren, insbesondere Temperatursensoren und/oder Vibrationssensoren, die insbesondere in Echtzeit (tatsächliche) Umgebungsparameter erfassen. Die Ausdrücke $GX(t)$, $GY(t)$ und $GZ(t)$ beschreiben insbesondere Gradientenwellenformen bzw. Gradientenpulse, die während der Magnetresonanzmessung appliziert und/oder verwendet werden.

Es wird abschließend noch einmal darauf hingewiesen, dass es sich bei den vorhergehend detailliert beschriebenen Verfahren sowie bei Magnetresonanzvorrichtung lediglich um Ausführungsbeispiele handelt, welche vom Fachmann in verschiedenster Weise modifiziert werden können, ohne den Bereich der Erfindung zu verlassen. Weiterhin schließt die Verwendung der unbestimmten Artikel "ein" bzw. "eine" nicht aus, dass die betreffenden Merkmale auch mehrfach vorhanden sein können. Ebenso schließt der Begriff "Einheit" nicht aus, dass die betreffenden Komponenten aus mehreren zusammenwirkenden Teil-Komponenten bestehen, die gegebenenfalls auch räumlich verteilt sein können.

### Patentansprüche

1. Computerimplementiertes Verfahren zum Abschätzen zumindest eines Abweichungswertes, insbesondere eines Maxwell-Terms, wobei jeder Abweichungswert eine Abweichung eines Ist-Gradientenmagnetfeldes von einem Soll-Gradientenmagnetfeld einer Magnetresonanzvorrichtung (10) beschreibt, umfassend,

   - Bereitstellen zumindest eines Gradientenwertes, wobei jeder Gradientenwert eine Gradientenstärke des jeweiligen Soll-Gradientenmagnetfeldes beschreibt,
   wobei die Magnetresonanzvorrichtung ein Hauptmagnetfeld in einer Hauptmagnetfeldrichtung erzeugt,
   - Abschätzen des zumindest einen Abweichungswertes durch Anwenden des zumindest einen Gradientenwertes auf ein Magnetfeldmodell,
   wobei gemäß dem Magnetfeldmodell die Abweichung des zumindest einen Ist-Gradientenmagnetfeldes von dem jeweiligen Soll-Gradientenmagnetfeld durch zumindest eine vektorielle Komponente in einer von der Hauptmagnetfeldrichtung abweichenden Raumrichtung beschrieben wird.

2. Verfahren nach Anspruch 1,
   wobei die zumindest eine vektorielle Komponente eine lineare Abhängigkeit von zumindest einer Koordinate einer Raumrichtung aufweist.

3. Verfahren nach einem der vorangehenden Ansprüche,

   wobei ein Vektorfeld des Hauptmagnetfeldes in der Hauptmagnetfeldrichtung ausgerichtet ist,
   wobei das Ist-Vektorfeld des zumindest einen Ist-Gradientenmagnetfeldes zumindest einen Vektor aufweist, der zumindest eine Vektorkomponente aufweist, die von der Hauptmagnetfeldrichtung abweicht, wobei der zumindest ein Abweichungswert diese Abweichung beschreibt.

4. Verfahren nach einem der vorangehenden Ansprüche,
wobei das zumindest eine Ist-Gradientenmagnetfeld ein erstes Ist-Gradientenmagnetfeld mit einem Magnetfeldgradienten in einer ersten Raumrichtung, ein zweites Ist-Gradientenmagnetfeld mit einem Magnetfeldgradienten in einer zweiten Raumrichtung und/oder ein drittes Ist-Gradientenmagnetfeld mit einem Magnetfeldgradienten in einer dritten Raumrichtung umfasst, wobei die erste, zweite und die dritte Raumrichtung orthogonal zueinander sind.

5. Verfahren nach Anspruch 4,

wobei die erste Raumrichtung eine X-Richtung, die zweite Raumrichtung eine *Y*-Richtung und die dritte Raumrichtung eine Z-Richtung sind, wobei die Z-Richtung die Hauptmagnetfeldrichtung ist,
wobei gemäß dem Magnetfeldmodell für den zumindest einen Abweichungswert gilt $B_{xx}=z \cdot GX$, $B_{xy} = 0$ für das erste Ist-Gradientenmagnetfeld, $B_{yx} = 0$, $B_{yy} = z \cdot GY$ für das zweite Ist-Gradientenmagnetfeld und/oder

$$B_{zx} = -x\frac{GZ}{2}, \quad B_{zy} = -y\frac{GZ}{2}$$ für das dritte Ist-Gradientenmagnetfeld,

wobei *GX* die Gradientenstärke in X-Richtung ist, wobei *GY* die Gradientenstärke in *Y*-Richtung ist, wobei *GZ* die Gradientenstärke in Z-Richtung ist, wobei x eine Koordinate in X-Richtung ist, wobei y eine Koordinate in *Y*-Richtung ist, wobei z eine Koordinate in Z-Richtung ist.

6. Verfahren nach einem der vorangehenden Ansprüche,
wobei anhand des bestimmten zumindest einen Abweichungswertes eine Korrektur von Magnetresonanzsignalen, insbesondere von einer Kodierung von Magnetresonanzsignalen, durchgeführt wird.

7. Verfahren nach Anspruch 6,
wobei die Korrektur eine Berechnung einer Larmorfrequenz in Abhängigkeit des zumindest einen Abweichungswertes umfasst.

8. Verfahren nach einem der vorangehenden Ansprüche,

wobei eine Rekonstruktion zumindest einer Magnetresonanzabbildung durchgeführt wird,
wobei bei der Rekonstruktion der zumindest einen Magnetresonanzabbildung durch die Abweichung des zumindest einen Ist-Gradientenmagnetfeldes hervorgerufene Phasenfehler anhand des zumindest einen Abweichungswertes korrigiert werden.

9. Verfahren nach einem der vorangehenden Ansprüche,
wobei das Verfahren ferner umfasst,

- Bereitstellen zumindest eines Parameters, der das Hauptmagnetfeld beschreibt,
- Abschätzen eines Gesamtmagnetfeldes anhand des zumindest einen Parameters, des zumindest einen Gradientenwertes und des zumindest einen Abweichungswertes.

10. Verfahren nach Anspruch 9,

wobei eine Magnetresonanzmessung durchgeführt wird,
wobei vor der Magnetresonanzmessung der zumindest eine Parameter des Hauptmagnetfeldes kalibriert wurde,
wobei während der Magnetresonanzmessung der kalibrierte zumindest eine Parameter, insbesondere in Echtzeit, rekalibriert wird,
wobei die Abschätzung des Gesamtmagnetfeldes anhand des kalibrierten zumindest einen Parameter erfolgt.

11. Systemsteuereinheit (22), die ausgebildet ist, ein Verfahren zum Abschätzen zumindest eines Abweichungswertes nach einem der Ansprüche 1 bis 9 auszuführen.

12. Magnetresonanzvorrichtung (10) mit einer Systemsteuereinheit (22) nach Anspruch 11,
wobei die Magnetresonanzvorrichtung (10) ausgebildet ist, ein Verfahren zum Abschätzen zumindest eines Abweichungswertes nach einem der Ansprüche 1 bis 10 auszuführen.

13. Computerprogrammprodukt, welches ein Programm umfasst und direkt in einen Speicher einer programmierbaren Systemsteuereinheit (22) einer Magnetresonanzvorrichtung (10) ladbar ist, mit Programmmitteln, um ein Verfahren nach einem der Ansprüche 1 bis 10 auszuführen, wenn das Programm in der Systemsteuereinheit (22) der Magnetresonanzvorrichtung (10) ausgeführt wird.

FIG 1

# FIG 2

# FIG 3

```
┌─────────────────┐
│                 │── S10
└─────────────────┘
         │
         ▼
┌─────────────────┐
│                 │── S20
└─────────────────┘
         │
         ▼
┌─────────────────┐
│                 │── S30
└─────────────────┘
```

# FIG 4

## FIG 5

FIG 6

FIG 7

FIG 8

FIG 9

FIG 10

FIG 11

Europäisches Patentamt
European Patent Office
Office européen des brevets

# EUROPÄISCHER RECHERCHENBERICHT

Nummer der Anmeldung

EP 22 16 8603

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | BAMMER R. ET AL: "Analysis and generalized correction of the effect of spatial gradient field distortions in diffusion-weighted imaging", MAGNETIC RESONANCE IN MEDICINE, Bd. 50, Nr. 3, 20. August 2003 (2003-08-20), Seiten 560-569, XP055871694, US ISSN: 0740-3194, DOI: 10.1002/mrm.10545 | 1,3,4,6, 9,11-13 | INV. G01R33/565 ADD. G01R33/389 |
| Y | * Kapitel "Theory" * ----- | 10 | |
| A | US 11 294 016 B1 (FOO THOMAS K F [US] ET AL) 5. April 2022 (2022-04-05) * Abbildung 1 * ----- | 1 | |
| X | YABLONSKIY DMITRIY A. ET AL: "Image artifacts in very low magnetic field MRI: The role of concomitant gradients", PROCEEDINGS OF THE INTERNATIONAL SOCIETY FOR MAGNETIC RESONANCE IN MEDICINE, 13TH MEETING PROCEEDINGS, 1. Juni 2005 (2005-06-01), Seite 1835, XP055961385, | 1-9, 11-13 | |
| Y | * das ganze Dokument * ----- -/-- | 10 | |

**RECHERCHIERTE SACHGEBIETE (IPC)**

G01R

Der vorliegende Recherchenbericht wurde für alle Patentansprüche erstellt

| Recherchenort | Abschlußdatum der Recherche | Prüfer |
|---|---|---|
| München | 15. September 2022 | Skalla, Jörg |

EPO FORM 1503 03.82 (P04C03)

Seite 1 von 3

Europäisches
Patentamt

European
Patent Office

Office européen
des brevets

## EUROPÄISCHER RECHERCHENBERICHT

Nummer der Anmeldung

EP 22 16 8603

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | ABDEL MONEM EL-SHARKAWY ET AL: "Monitoring and correcting spatio-temporal variations of the MR scanner's static magnetic field", MAGNETIC RESONANCE MATERIALS IN PHYSICS, BIOLOGY AND MEDICINE, CHAPMAN AND HALL, LONDON, GB, Bd. 19, Nr. 5, 17. Oktober 2006 (2006-10-17), Seiten 223-236, XP019445955, ISSN: 1352-8661, DOI: 10.1007/S10334-006-0050-2 * Abbildungen 1,2 * ----- | 10 | |
| A | DE 10 2017 208335 A1 (SIEMENS HEALTHCARE GMBH [DE]) 22. November 2018 (2018-11-22) * Absatz [0069] – Absatz [0078] * ----- | 1-13 | |
| A | BERNSTEIN M A ET AL: "CONCOMITANT GRADIENT TERMS IN PHASE CONTRAST MR: ANALYSIS AND CORRECTION", MAGNETIC RESONANCE IN MEDICINE, WILEY-LISS, US, Bd. 39, Nr. 2, 1998, Seiten 300-308, XP000734742, ISSN: 0740-3194 * Abbildung 3 * ----- | 1,8 | RECHERCHIERTE SACHGEBIETE (IPC) |

-/--

Der vorliegende Recherchenbericht wurde für alle Patentansprüche erstellt

| Recherchenort | Abschlußdatum der Recherche | Prüfer |
|---|---|---|
| München | 15. September 2022 | Skalla, Jörg |

EPO FORM 1503 03.82 (P04C03)

**Seite 2 von 3**

Europäisches Patentamt

European Patent Office

Office européen des brevets

**EUROPÄISCHER RECHERCHENBERICHT**

Nummer der Anmeldung

EP 22 16 8603

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | CHIZHIK VLADIMIR ET AL: "Reduction of Effect of Concomitant Gradients in Low Magnetic Field MRI via Optimization of Gradient Magnetic System", APPLIED MAGNETIC RESONANCE, SPRINGER VERLAG, VIENNA, AU, Bd. 48, Nr. 7, 17. Juni 2017 (2017-06-17), Seiten 687-698, XP036269293, ISSN: 0937-9347, DOI: 10.1007/S00723-017-0909-6 [gefunden am 2017-06-17] * chapter 2 * ----- | 1 | |
| | | | **RECHERCHIERTE SACHGEBIETE (IPC)** |

Der vorliegende Recherchenbericht wurde für alle Patentansprüche erstellt

| Recherchenort | Abschlußdatum der Recherche | Prüfer |
|---|---|---|
| München | 15. September 2022 | Skalla, Jörg |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 22 16 8603

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-09-2022

| Im Recherchenbericht angeführtes Patentdokument | Datum der Veröffentlichung | Mitglied(er) der Patentfamilie | Datum der Veröffentlichung |
|---|---|---|---|
| US 11294016 B1 | 05-04-2022 | CN 114587332 A<br>US 11294016 B1 | 07-06-2022<br>05-04-2022 |
| DE 102017208335 A1 | 22-11-2018 | DE 102017208335 A1<br>US 2018335488 A1 | 22-11-2018<br>22-11-2018 |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

**In der Beschreibung aufgeführte Patentdokumente**

- US 5877629 A
- US 5923168 A
- US 6011392 A

**In der Beschreibung aufgeführte Nicht-Patentliteratur**

- **WANG et al.** FMRI based on transition-band balanced SSFP in comparison with EPI on a high-performance 0.55 T scanner. *Magn Reson Med.,* 2021, vol. 85, 3196-3210